# EUROPÄISCHE PATENTSCHRIFT

(11) **EP 3 948 963 B1**
(45) Veröffentlichungstag und Bekanntmachung des Hinweises auf die Patenterteilung: **13.09.2023**
(21) Anmeldenummer: 20717817.9
(22) Anmeldetag: 02.04.2020
(51) Int. Cl.: H10N 60/01

(54) **FERTIGLEITER-ANORDNUNG FÜR EINEN NB3SN-SUPRALEITERDRAHT UND VERFAHREN ZUR HERSTELLUNG EINES SUBELEMENTS FÜR EINEN NB3SN-SUPRALEITERDRAHT**
FINISHED CONDUCTOR ARRANGEMENT FOR AN NB3SN SUPERCONDUCTOR WIRE AND METHOD FOR PRODUCING A SUBELEMENT FOR AN NB3SN SUPERCONDUCTOR WIRE
AGENCEMENT DE CONDUCTEURS DE FINITION POUR UN FIL SUPRACONDUCTEUR NB3SN ET PROCÉDÉ DE FABRICATION D'UN SOUS-ÉLÉMENT POUR UN FIL SUPRACONDUCTEUR NB3SN

(30) Priorität: 05.04.2019 DE 102019204926
(43) Veröffentlichungstag der Anmeldung: 09.02.2022
(73) Patentinhaber: Bruker EAS GmbH, 63450 Hanau (DE)
(72) Erfinder: WANIOR, Matheus, 63571 Gelnhausen (DE); ABÄCHERLI, Vital, 63526 Erlensee (DE); BÜHLER, Carl, 63505 Langenselbold (DE); SAILER, Bernd, 63755 Alzenau (DE); SCHLENGA, Klaus, 76149 Karlsruhe (DE); THÖNER, Manfred, 63599 Biebergemünd (DE); FIELD, Michael, Hoboken, New Jersey 07030 (US)
(74) Vertreter: Kohler Schmid Möbus Patentanwälte
(86) Internationale Anmeldenummer: PCT/EP2020/059382
(87) Internationale Veröffentlichungsnummer: WO 2020/201414

(56) Entgegenhaltungen:
- DE-A1-102012 218 222
- US-A1- 2005 178 472
- US-B2- 7 585 377

## Beschreibung

Die Erfindung betrifft eine Fertigleiter-Anordnung für einen Nb3Sn-Supraleiterdraht, umfassend
- mehrere aneinander anliegende Subelemente, die jeweils Nb und Sn enthalten und die jeweils im Außenquerschnitt hexagonal ausgebildet sind, und
- eine Außenstruktur, die Cu enthält und die die aneinander anliegenden Subelemente umgibt, wobei die Außenstruktur im Außenquerschnitt rund ausgebildet ist,
   wobei die Subelemente jeweils ausgebildet sind mit
- einem Sn-haltigen Kern,
- einer inneren Matrix, die Cu enthält und die den Sn-haltigen Kern umgibt,
- einen Bereich von aneinander anliegenden Nb-haltigen Stabelementen, die jeweils im Außenquerschnitt hexagonal ausgebildet sind, insbesondere wobei die Nb-haltigen Stabelemente jeweils mit einem Nb-haltigen Kernfilament und einer Cu-haltigen Filamenthülle ausgebildet sind, und
- einer äußeren Matrix, die Cu enthält und den Bereich von Nb-haltigen Stabelementen umgibt.

Eine solche Fertigleiter-Anordnung ist beispielsweise bekannt geworden durch die US 7,585,377 B2.

Supraleitermaterialien können praktisch ohne ohmsche Verluste Strom tragen, und werden beispielsweise zum Bau von Magnetspulen eingesetzt, mit denen besonders große Magnetfeldstärken erzeugt werden können.

Ein wichtiges Supraleitermaterial, insbesondere für den Bau von Magnetspulen, ist Nb3Sn. Da Nb3Sn sich nicht plastisch verformen lässt, wird für die Herstellung eines Nb3Sn-Supraleiterdrahts meist zunächst ein Vorleiter gefertigt, der Nb und Sn enthält, typischerweise mit Cu als Matrixmaterial. Der Vorleiter wird durch Querschnittsverjüngende Umformung und Bündelung zu einem Fertigleiter verarbeitet. Dieser Fertigleiter wird meist nochmals einer querschnittsverjüngenden Umformung unterzogen, und sodann in eine gewünschte Geometrie gebracht, etwa durch Wickeln einer Spule. Anschließend wird in einer Reaktionswärmebehandlung die supraleitende Nb3Sn-Phase erzeugt, wodurch aus dem Fertigleiter der fertige Nb3Sn-Supraleiterdraht entsteht. Die Herstellung eines Nb3Sn-Supraleiterdrahts ist somit ein mehrstufiger und insgesamt schwieriger Prozess. Dabei haben sich mehrere Routen entwickelt, die im Vorgehen und in den für die Qualität des fertigen Nb3Sn-Supraleiterdrahts relevanten, ablaufenden Reaktionen erhebliche Unterschiede aufweisen.

Bei der so genannten Bronze-Route wird das Sn, das mit dem Nb des Vorleiters reagieren soll, im Vorleiter über eine Bronze-Matrix zur Verfügung gestellt. Die Bronze-Route ist vergleichsweise einfach auszuführen, jedoch begrenzt der Sn-Gehalt der Bronze-Matrix die Entstehung der Nb3Sn-Phase.

Bei der "internal tin" (Internes Zinn)-Route ist im Vorleiter üblicherweise zentral eine Zinnquelle angeordnet, wobei in der Reaktionswärmebehandlung das Sn aus dem Kern durch die Cu-Matrix hindurch mit dem Nb des Vorleiters reagiert. Im Falle eines Vorgehens nach dem "Powder in Tube"-Prinzip (abgekürzt PIT) wird dabei Sn-haltiges Pulver in einem Röhrchen aus Nb oder einer Nb-Legierung angeordnet. Das gefüllte Nb-Röhrchen wird in einer Cu-haltigen Umhüllung angeordnet, das mit einem hexagonalen Außenquerschnitt gefertigt sein kann, wodurch ein PIT-Element erhalten wird. Die im Außenquerschnitt hexagonalen PIT-Elemente werden gezogen und gebündelt und können mit Füllelementen umgeben werden, die außen kreisbogenförmig und innen entsprechend den hexagonal profilierten PIT-Elementen profiliert sind, und in einem Cu-Stabilisierungshüllrohr angeordnet werden. In der Reaktionswärmebehandlung reagiert das Sn im PIT-Kern direkt mit dem umhüllenden Nb-Rohr. Ein typischer PIT-Prozess ist beispielsweise durch die EP 3 062 359 B1 beschrieben. Ein ähnliches Vorgehen beschreibt die EP 2 779 258 B1.

Die "internal tin"-Route kann auch gemäß dem "Restack Rod Process" (abgekürzt RRP, "Umbündelung der Stäbe-Prozess")-Prinzip erfolgen. Hierbei wird eine Vielzahl von hexagonalen Nb-Filamenten (auch genannt Nb-haltige Stabelemente), typischerweise jeweils enthaltend einen Nb-Stab und eine umgebende Cu-Filamenthülle, ringartig gebündelt und innen und außen von einer Cu-Matrix umgeben. Im Inneren wird ein Zentrum enthaltend Sn angeordnet, und außen werden eine Diffusionsbarriere und eine runde Cu-Hülle angeordnet. Solchermaßen ausgebildete Subelemente werden auf einen hexagonalen Außenquerschnitt gezogen, gebündelt und zur Ausbildung eines Drahtes von einer Kupfermatrix umgeben, vgl. die US 7,585,377 B2. Eine Bündelung von runden RRP-Subelementen in einem Mantelrohr ist auch aus der DE 10 2012 218 222 A1 bekannt geworden. Mit dem RRP-Prozess können meist besonders große supraleitende Stromtragfähigkeiten eines fertigen Nb3Sn-Supraleiterdrahts erreicht werden.

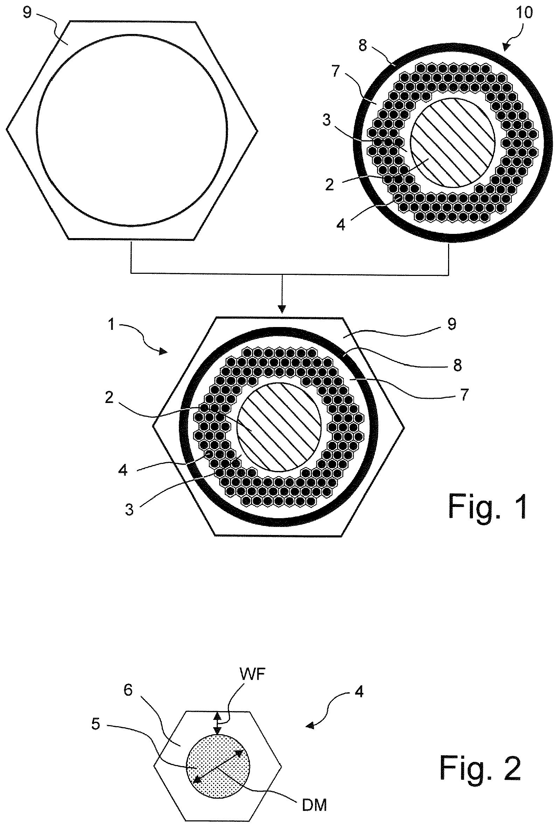

In der Praxis, wenn eine größere Zahl von RRP-Subelementen in einem Draht zusammengefasst werden soll, beispielsweise wenigstens 54 Subelemente, wird die Kupfermatrix für den Draht (oder Fertigleiter) mit einer runden Außenform und einer hexagonalen Innenform gefertigt, und die entsprechend in eine hexagonale Form gebündelten Subelemente werden in diese Innenform eingesetzt. Wenn nun der Fertigleiter nochmals einer querschnittsverjüngenden Umformung unterzogen wird, kommt es zu einer teilweise erheblichen Deformation von äußeren Subelementen, insbesondere nahe den Ecken der hexagonalen Innenform. Solche Deformationen sind beispielsweise in E. Barzi et al., "Performance of Nb3Sn RRP Strands and Cables Based on a 108/127 Stack Design", FERMILAB-PUB-06-298-TD, 4MW06, dortige Fig. 1, zu erkennen. Diese Deformationen gefährden den gewünschten Ablauf der Reaktionswärmebehandlung in dem betroffenen Subelement, so dass in diesem Subelement kein Nb3Sn oder weniger Nb3Sn als gewünscht entsteht, und entsprechend die Stromtragfähigkeit sinkt. Zudem besteht die Gefahr, dass sich Sn aus dem deformierten Subelement unkontrolliert ausbreitet, etwa in die Kupfermatrix des Drahtes oder in die Cu-Hüllen von anderen Subelementen, wodurch der elektrische Widerstand des Kupfers im Draht erhöht werden kann (niedriger RRR-Wert) und damit dessen Schutzfunktion zur Vermeidung oder Abmilderung eines schlagartigen, irreversiblen Verlustes der Supraleitung in einem fertigen Magneten (Quench) beeinträchtigt werden kann.

Auch bei der Umformung der zunächst im Außenquerschnitt runden RRP-Subelemente auf einen hexagonalen Außenquerschnitt wird das Innere des Subelements ungleichmäßig verformt. Insbesondere kann Nb-Material der Nb-Filamente zu den Hexagonecken hin radial nach außen verschoben werden, so dass es bei der Reaktionswärmebehandlung auf Grund der größeren Entfernung zur im Zentrum des Subelements befindlichen Sn-Quelle nicht mehr ausreichend bzw. verspätetet mit Sn versorgt wird, und das teure Nb zur supraleitenden Stromtragfähigkeit nichts mehr beitragen kann. Zudem können auch die ungleichmäßigen Verformungen (etwa eine Ausdünnung einer Diffusionsbarriere) dazu führen, dass Sn aus dem Subelement während der Reaktionswärmebehandlung in unerwünschte Bereiche vordringen kann, etwa in den Bereich der eigenen Cu-Hülle (auch genannt Cu-Hüllstruktur) oder auch Cu-Hüllen benachbarter Subelemente, was dort wiederum den ohmschen Widerstand erhöht und damit die Schutzfunktion beeinträchtigt. Die ungleichmäßige Verformung kann zudem dazu führen, dass zur Bildung von Nb3Sn vorgesehenes Precursormaterial (Stabelemente und gegebenenfalls Barrieren) nach der Umformung Kontakt haben (filament bridging) oder zu nahe beieinander liegen. Dies erschwert die gleichmäßige Eindiffusion von Sn in das ehemals vereinzelte Nb-Precursormaterial und/oder verändert lokal die Zusammensetzung des Leiters. Während der Wärmebehandlung kann so keine vollständige und stöchiometrische Nb3Sn-Bildung stattfinden, was die maximal erreichbare Stromtragfähigkeit signifikant reduziert. Gleichzeitig verschlechtert die gegenseitige Kontaktierung von Precursormaterial die mechanischen Eigenschaften des Leiters während der Umformung, was zu Drahtabrissen führen kann.

Eine speziellere Variante eines Fertigleiters für einen Nb3Sn-Supraleiterdrahts sieht die Bündelung von NbCu-Stäben und Cu-Stäben mit NaCl-Füllung in einem Cu-Mantel vor. Das NaCl wird mit Wasser ausgespült und durch Sn ersetzt, vgl. US 5,534,219 A.

### Aufgabe der Erfindung

Es ist Aufgabe der Erfindung, einen Fertigleiter für einen Nb3Sn-Supraleiterdraht zur Verfügung zu stellen, mit dem eine für den Leiterquerschnitt hohe supraleitende Stromtragfähigkeit erreicht werden kann, und die Gefahr einer Verunreinigung von schützenden Kupferanteilen durch Sn verringert werden kann.

### Kurze Beschreibung der Erfindung

Diese Aufgabe wird erfindungsgemäß gelöst durch eine Fertigleiter-Anordnung der eingangs genannten Art, die dadurch gekennzeichnet ist,
dass die Außenstruktur mit einem Außenrohr ausgebildet ist, das im Außenquerschnitt und im Innenquerschnitt rund ausgebildet ist,
dass zwischen dem Außenrohr und den aneinander anliegenden Subelementen ein oder mehrere Füllelemente angeordnet sind, die nach radial außen ein rundes Profil zur direkten oder indirekten Anlage an eine Innenseite des Außenrohrs aufweisen, und die nach radial innen ein gezacktes Profil zur Anlage an die aneinander anliegenden Subelemente aufweisen,
wobei an die aneinander anliegenden Subelemente außenseitig das eine oder die mehreren Füllelemente angelegt sind, und an das radial äußere, runde Profil des einen oder der mehreren Füllelemente direkt oder indirekt das Außenrohr angelegt ist,
und dass die Gesamtheit der Füllelemente nach radial innen hin ein näherungsweise kreisförmiges Gesamtprofil ausbildet.

Mit dem erfindungsgemäßen Fertigleiter ist es möglich, einen Nb3Sn-haltigen Supraleiterdraht gemäß dem RRP-Prinzip mit einem besonders hohen Nb3Sn-Gehalt und damit einer (für die Querschnittsfläche des Nb3Sn-Supraleiterdrahts) besonders großen Stromtragfähigkeit zu erhalten. Gleichzeitig kann dabei eine Sn-Verunreinigung der Außenstruktur, insbesondere des Außenrohrs, und auch von äußeren Matrices der Subelemente mit hoher Zuverlässigkeit vermieden werden.

Im Rahmen der vorliegenden Erfindung werden an die aneinander anliegenden Subelemente außenseitig ein oder mehrere Füllelemente angelegt. Dadurch bildet sich ein kreisförmiges Außenprofil aus, das an die im Querschnitt kreisrunde Innenseite des Außenrohrs direkt oder indirekt (über ein oder mehrere Zwischenstrukturen, die im Querschnitt meist innen und außen ebenfalls kreisförmig ausgebildet sind) angelegt werden kann. Weiterhin bilden die Füllelemente nach radial innen hin ein gezacktes, insgesamt aber näherungsweise kreisförmiges Innenprofil aus; an dieses Innenprofil werden die aneinander anliegenden hexagonalen Subelemente angelegt.

Dadurch können zum einen Hohlräume im Fertigleiter, insbesondere zwischen der Innenseite des Außenrohrs (oder einer innersten Zwischenstruktur) und dem Außenprofil der Gesamtheit der aneinander anliegenden Subelemente vermieden werden. Zum anderen können ausgeprägte Ecken (wie sie im Falle eines herkömmlichen, insgesamt näherungsweise hexagonalen Außenprofils der aneinander anliegenden Subelemente vorhanden wären) bei den aneinander anliegenden Subelementen vermieden werden.

Unter Verwendung der erfindungsgemäß vorgesehenen Füllelemente und der erfindungsgemäßen, näherungsweise kreisförmigen Anordnung der Subelemente ist es möglich, bei einer querschnittsverringernden Umformung des Fertigleiters ungleichmäßige Verformungen an den Subelementen zu verringern bzw. zu minimieren. Im Rahmen der Erfindung können sich alle Subelemente weitgehend gleichmäßig im Querschnitt verkleinern, insbesondere unter näherungsweiser Beibehaltung von allen Wandstärkenverhältnissen über ihren jeweiligen gesamten Umfang. Es gibt keine lokalen, besonders verformten Subelemente, etwa an ausgeprägten Ecken. Entsprechend bleiben die für das Reaktionsglühen vorgesehenen Diffusionslängen erhalten, und etwaige eingerichtete Diffusionsbarrieren werden nicht beschädigt. Das Reaktionsglühen nach der querschnittsverringernden Umformung des Fertigleiters kann störungsfrei ablaufen, wobei eine hohe Stromtragfähigkeit erreicht wird und Sn-Kontaminationen in die im normalleitenden Zustand hoch leitfähigen Bereiche des Nb3Sn-Supraleiterdrahts (mit Schutzfunktion im Quenchfall) vermieden werden.

Man beachte, dass zur Einrichtung des näherungsweise kreisförmigen Außenprofils der Gesamtheit der aneinander anliegenden Subelemente bzw. des entsprechenden näherungsweise kreisförmigen Innenprofils der Gesamtheit der Formelemente bevorzugt wenigstens 40, besonders bevorzugt wenigstens 60 Subelemente, und ganz besonders bevorzugt wenigstens 80 Subelemente im Fertigleiter zusammengefasst werden. Ein annähernd kreisförmiges Außenprofil der Gesamtheit der aneinander anliegenden Subelemente liegt insbesondere dann vor, wenn der kleinstmögliche Umkreis, der die radial am weitesten vorstehenden Spitzen der Gesamtheit der aneinander anliegenden Subelemente enthält, zwischen dem Umkreis und der Außenseite der Gesamtheit der aneinander anliegenden Subelemente keine weiteren Subelemente gleicher Größe mehr vollständig aufnehmen könnte.

Das innen und außen kreisförmige Außenrohr ist besonders kostengünstig und einfach herzustellen. Das oder die Füllelemente sind ebenfalls vergleichsweise kostengünstig herzustellen, insbesondere wenn sie jeweils nur einen kleinen Teil des Umfangs des runden Profils der Gesamtheit der Füllelemente abdecken, beispielsweise einen Umfangs-Teilwinkel von 45° oder weniger; die Füllelemente können beispielsweise aus Vollmaterial gefräst und/oder auf große Längen profilgewalzt werden. Bevorzugt weist die Fertigleiter-Anordnung wenigstens zwei, besonders bevorzugt wenigstens 6, ganz besonders bevorzugt wenigstens 12 Füllelemente auf.

### Bevorzugte Ausführungsformen des Fertigleiters

Bei einer bevorzugten Ausführungsform des erfindungsgemäßen Fertigleiters ist vorgesehen, dass die Fertigleiter-Anordnung mehrere Füllelemente umfasst, und dass radial am weitesten vorstehende Spitzen der Gesamtheit der aneinander anliegenden Subelemente und die runden Profile der Füllelemente sich zu einer kreisförmigen Kontur ergänzen, wobei die Füllelemente so ausgebildet sind, dass die kreisförmige Kontur einen minimalen Radius aufweist. Dadurch ist ein besonders großer Füllungsgrad (Flächenanteil im Querschnitt) der Fertigleiter-Anordnung mit Subelementen möglich, und damit ein besonders großer Füllungsgrad des späteren, fertigen Nb3Sn-Supraleiterdrahts mit Nb3Sn. Bei dieser Bauform trennen die am weitesten vorstehenden Spitzen der aneinander anliegenden Subelemente dort zusammenlaufende Füllelemente in Umfangsrichtung voneinander ab.

Bei einer alternativen, vorteilhaften Ausführungsform ist vorgesehen, dass das oder die Füllelemente einen umlaufenden Füllelemente-Ring ausbilden, innerhalb dessen die Gesamtheit der aneinander anliegenden Subelemente angeordnet ist, insbesondere wobei für eine minimale radiale Wandstärke WSₘᵢₙ des Füllelemente-Rings gilt: WSₘᵢₙ≥0,3^{∗}KL_{sub}, mit KL_{sub}: Kantenlänge eines hexagonalen Subelements. Durch den umlaufenden Füllelemente-Ring ist es möglich, mit diesem funktionelle oder strukturelle Aufgaben zu übernehmen; eine entsprechende separate Zwischenstruktur für dieselbe Aufgabe kann entfallen. Insbesondere können die Füllelemente bei der plastischen Verformung zwischen der Außenstruktur (oder eines Teils davon) und den aneinander anliegenden Subelementen vermitteln, oder einen umlaufend zur Verfügung stehenden ohmschen Strompfad bilden (wofür sie aus elementarem Cu gefertigt sein können) oder auch als Diffusionsbarriere dienen (wofür sie beispielsweise aus Nb, Ta oder V gefertigt sein können).

Bevorzugt ist eine Weiterbildung dieser Ausführungsform, bei der der Füllelemente-Ring mehrere Füllelemente umfasst, und dass Stöße zwischen in Umfangsrichtung benachbarten Füllelementen im Füllelemente-Ring zumindest teilweise, bevorzugt vollständig, schräg zur radialen Richtung verlaufen, insbesondere wobei für eine kleinste Verlaufslänge VLₘᵢₙ aller Verlaufslängen der jeweiligen Stöße gilt: VLₘᵢₙ≥2^{∗}WSₘᵢₙ, mit WSₘᵢₙ: minimale radiale Wandstärke des Füllelemente-Rings. Mittels schräger Stöße kann eine Diffusion von Verunreinigungen, etwa Sn, entlang der Stöße verzögert werden (entsprechend der Verlängerung des Diffusionspfades entlang des Stoßes). Bevorzugt gilt auch VLₘᵢₙ≥4^{∗}WSₘᵢₙ. Alternativ können auch in radialer Richtung verlaufende Stöße vorgesehen sein, die besonders einfach zu fertigen sind.

Bei einer bevorzugten Ausführungsform enthalten das eine oder die mehreren Füllelemente Cu. Kupfer in den Füllelementen ermöglicht gute Umformungseigenschaften, und ist vergleichsweise kostengünstig. Zudem kann Cu im Quenchfall als elektrische Stabilisierung dienen und entsprechend eine Schutzfunktion bieten. Meist sind hierfür 50 Gew% Cu oder mehr in den Füllelementen enthalten, und insbesondere können die Füllelemente aus elementarem Cu bestehen.

Bei einer alternativen Weiterbildung der Ausführungsform mit einem umlaufenden Füllelemente-Ring ist vorgesehen, dass die Füllelemente des Füllelemente-Rings aus einem Material gefertigt sind, das dazu geeignet ist, die Diffusion von Sn aus den Subelementen in das Außenrohr während einer Reaktionswärmebehandlung, bei der das Nb und Sn aus den Subelementen zu Nb3Sn reagieren, zu blockieren oder zu behindern,
insbesondere wobei die Füllelemente Nb, Ta und/oder V enthalten. Dadurch wird die Außenstruktur der Fertigleiter-Anordnung vor einer Verunreinigung mit Sn geschützt, und für die Außenstruktur, insbesondere den Außenring, kann ein hoher RRR-Wert und damit eine gute Schutzfunktion im Quenchfall sichergestellt werden. Typischerweise enthalten die Füllelemente hierfür wenigstens 50 Gew% Nb, Ta und/oder V, um die die Diffusion von Sn zu blockieren. Ansonsten kann ein Material als für die Diffusion von Sn als blockierend oder behindernd angesehen werden, wenn die Diffusionsgeschwindigkeit von Sn durch dieses Material hindurch maximal 1/10 der Diffusionsgeschwindigkeit durch das Material des Außenrohrs beträgt, bezogen auf einen Temperaturbereich von Raumtemperatur bis 800°C (was dem maximalen Bereich einer typischen Reaktionswärmebehandlung entspricht).

Bevorzugt ist eine Ausführungsform, bei der die Fertigleiter-Anordnung mehrere Füllelemente mit unterschiedlicher Geometrie umfasst,
insbesondere wobei insgesamt zwölf Füllelemente mit zwei verschiedenen Geometrien vorhanden sind. Durch den Einsatz unterschiedlicher Geometrien (Gestalten) der Füllelemente kann meist ein größerer Füllungsgrad des Fertigleiters mit Subelementen erreicht werden. Meist sind 2, 3 oder 4 unterschiedliche Geometrien in der Praxis ausreichend.

Bei einer bevorzugten Ausführungsform ist eine Zwischenstruktur, insbesondere ein Zwischenrohr, radial zwischen der Innenseite des Außenrohrs und den runden Profilen des oder der Füllelemente vorhanden. Mit der Zwischenstruktur kann eine strukturelle oder funktionelle Aufgabe adressiert werden, beispielsweise eine Vermittlung zwischen den plastischen Verformungseigenschaften des Außenrohrs und der aneinander anliegenden Subelemente, oder das zur Verfügung stellen eines umlaufenden, ohmschen Strompfades, oder auch das zur Verfügung stellen einer Diffusionsbarriere.

Bevorzugt ist dabei eine Weiterbildung dieser Ausführungsform, bei der die Zwischenstruktur aus einem Material gefertigt ist, das dazu geeignet ist, die Diffusion von Sn aus den Subelementen in das Außenrohr während einer Reaktionswärmebehandlung, bei der das Nb und Sn aus den Subelementen zu Nb3Sn reagieren, zu blockieren oder zu behindern,
insbesondere wobei die Zwischenstruktur Nb, Ta und/oder V enthält. Typischerweise enthält die Zwischenstruktur dabei wenigstens 50 Gew% Nb, Ta und/oder V, um die Diffusion von Sn zu blockieren. Ansonsten kann ein Material als für die Diffusion von Sn als blockierend oder behindernd angesehen werden, wenn die Diffusionsgeschwindigkeit von Sn durch dieses Material hindurch maximal 1/10 der Diffusionsgeschwindigkeit durch das Material des Außenrohrs beträgt, bezogen auf einen Temperaturbereich von Raumtemperatur bis 800°C (was dem maximalen Bereich einer typischen Reaktionswärmebehandlung entspricht). Durch die Blockierung von Sn durch die Zwischenstruktur kann ein hoher RRR-Wert und damit eine gute Schutzfunktion im Quenchfall im Außenrohr sichergestellt werden.

Bevorzugt ist weiterhin eine Ausführungsform, bei der die Subelemente weiterhin ausgebildet sind mit
- einer Diffusionsbarriere, die die äußere Matrix radial umgibt, und
- einer Hüllstruktur, die Cu enthält und die die Diffusionsbarriere radial umgibt.

Mittels der Diffusionsbarriere der Subelemente kann ein Vordringen von Sn in die eigene Hüllstruktur oder auch in die Hüllstruktur eines benachbarten Subelementes, und schließlich auch in den Bereich der Füllelemente oder der Außenstruktur der Fertigleiter-Anordnung verhindert werden. Einer Diffusionsbarriere im Bereich der Außenstruktur bedarf es dann nicht (diese kann aber für eine zusätzliche Sicherheit vorgesehen sein).

Bevorzugt ist eine Ausführungsform, bei der in der Fertigleiter-Anordnung eine Zentralstruktur vorhanden ist, die von den aneinander anliegenden Subelementen umgeben ist, wobei die Zentralstruktur Cu-haltig ist, insbesondere wobei die Zentralstruktur ein oder mehrere Zentralelemente enthält, die im Außenquerschnitt hexagonal ausgebildet sind. Mit der Cu-haltigen Zentralstruktur kann das Umformungsverhalten verbessert werden. Im Querschnitt hexagonale Zentralelemente können zusammen mit den Subelementen besonders leicht gebündelt werden.

In den Rahmen der vorliegenden Erfindung fällt auch ein Verfahren zur Fertigung eines Nb₃Sn-haltigen Supraleiterdrahts, umfassend die folgenden Schritte:
- eine erfindungsgemäße, oben beschriebene Fertigleiter-Anordnung wird einer querschnittsreduzierenden Umformung unterzogen;
- die umgeformte Fertigleiter-Anordnung wird in eine gewünschte geometrische Form gebracht, insbesondere zu einer Spule gewickelt;
- die in Form gebrachte Fertigleiter-Anordnung wird einer ReaktionsWärmebehandlung unterzogen, bei der das Nb und Sn aus den Subelementen zu Nb3Sn reagieren. Durch dieses Verfahren kann auf einfache Weise ein Nb3Sn-haltiger Supraleiterdraht (auch einfach genannt Nb3Sn-Supraleiterdraht) gefertigt werden, der eine hohe Stromtragfähigkeit aufweist, und bei dem Sn-Verunreinigungen von (normalleitend) hoch leitfähigen Bereichen weitgehend vermieden werden können.

Besonders bevorzugt ist eine Variante des oben beschriebenen Verfahrens, bei dem vorgesehen ist,
dass die Subelemente ausgebildet werden mit einer Hüllstruktur, die Cu enthält und an die die äußere Matrix radial innen direkt oder indirekt angelegt wird, dass zur Fertigung eines jeweiligen Subelements für die Fertigleiter-Anordnung die Hüllstruktur separat mit einem runden Innenquerschnitt und einem hexagonalen Außenquerschnitt gefertigt wird, und die übrigen Teile des Subelements anschließend in den runden Innenquerschnitt der Hüllstruktur eingesetzt werden, und dass die jeweiligen Subelemente einer querschnittsreduzierenden Umformung unterzogen werden und zu einer erfindungsgemäßen, oben beschriebenen Fertigleiter-Anordnung gebündelt werden. Durch die separat gefertigte Hüllstruktur mit hexagonalem Außenquerschnitt und rundem Innenquerschnitt wird erreicht, dass die querschnittsreduzierende Umformung des Subelements keine ungleichmäßigen Verformungen am Subelement erzeugt, und entsprechend gleichmäßig verformte Subelemente erhalten werden können, die nach dem Reaktionsglühen einen hohen Flächenanteil von Nb3Sn aufweisen, und bei denen ein Ausdiffundieren von Sn nach radial außen (etwa wegen beschädigter Diffusionsbarrieren oder lokal verringerter Wandstärken) minimiert ist (siehe dazu unten das weitere erfindungsgemäße Verfahren, einschließlich seiner Varianten). Zudem kann ein "filament bridging" reduziert werden, was die maximal erreichbare supraleitende Stromtragfähigkeit und die Umformeigenschaften weiter verbessert.

### Verfahren zur Herstellung eines Subelements für einen Nb3Sn-Supraleiterdraht

In den Rahmen der vorliegenden Erfindung fällt weiterhin ein Verfahren zur Herstellung eines Subelements für einen Nb3Sn-Supraleiterdraht, wobei das Subelement Nb und Sn enthält und im Außenquerschnitt hexagonal ausgebildet ist,
und wobei das Subelement ausgebildet ist mit
   - einem Sn-haltigen Kern,
   - einer inneren Matrix, die Cu enthält und die den Sn-haltigen Kern umgibt,
   - einen Bereich von aneinander anliegenden Nb-haltigen Stabelementen, die jeweils im Außenquerschnitt hexagonal ausgebildet sind, insbesondere wobei die Nb-haltigen Stabelemente jeweils mit einem Nb-haltigen Kernfilament und einer Cu-haltigen Filamenthülle ausgebildet sind,
   - einer äußeren Matrix, die Cu enthält und den Bereich von Nb-haltigen Stabelementen umgibt,
   - einer Hüllstruktur, die Cu enthält und an der die äußere Matrix radial innen direkt oder indirekt anliegt, dadurch gekennzeichnet,
dass die Hüllstruktur separat mit einem runden Innenquerschnitt und einem hexagonalen Außenquerschnitt gefertigt wird,
und dass die übrigen Teile des Subelements anschließend in den runden Innenquerschnitt der Hüllstruktur eingesetzt werden.

Im Rahmen der vorliegenden Erfindung ist es vorgesehen, bei den Subelementen eine hexagonale Außenform nicht dadurch zu erhalten, dass bei einem zunächst runden Subelement bei einer querschnittsverringernden Umformung gleichzeitig, etwa durch einen entsprechend geformten Ziehstein, eine hexagonale Außenform aufgeprägt wird. Vielmehr sieht die vorliegende Erfindung vor, bei der Fertigung von RRP-Subelementen eine (äußere) Hüllstruktur mit einem hexagonalen Außenquerschnitt und einem runden Innenquerschnitt zu fertigen, und dann in den runden Innenquerschnitt die übrigen Teile des Subelements einzusetzen, so dass bei einer querschnittsreduzierenden Umformung dann die hexagonale Außenform einfach beibehalten werden kann.

Wird einem zunächst runden Subelement, wie beispielsweise in der US 7,585,377 B2, Sp. 7, Z. 24-28, durch Umformung eine hexagonale Außenform aufgeprägt, so wird dabei die innere Struktur verzerrt. Insbesondere wird Material aus dem Inneren des Subelements in Richtung der Hexagonecken verschoben, unter Entzug von Material nahe den Längsseiten des Hexagons. Bezogen auf Diffusionswege von Sn aus dem Kern des Subelements stellen die Bereiche nahe den Längsseiten des Hexagons die kürzesten Diffusionswege bereit. Beim Reaktionsglühen muss dann die Prozessführung auf diese Bereiche mit den kürzesten Diffusionswegen eingestellt werden, um ein vollständiges Durchreagieren des Nb-haltigen Bereichs der aneinander anliegenden Nb-haltigen Stabelemente bzw. ein radiales Ausbreiten von Sn in die äußere Matrix oder gar in die Hüllstruktur zu verhindern. Dadurch wird viel teures Nb-Material, das durch die Umformung in den Bereich nahe den Hexagonecken verschoben wurde, während der Reaktionsglühens nicht von Sn erreicht, und kann somit zur supraleitenden Stromtragfähigkeit nichts beitragen. In vielen Fällen kann auch eine geringfügige Inhomogenität dazu führen, dass die Ausdünnung der aneinander anliegenden Nb-haltigen Stabelemente oder einer Diffusionsbarriere nahe den Längsseiten des Hexagons lokal so stark wird, dass es zu einer lokalen Kontamination (etwa in die eigene äußere Matrix und die eigene Hüllstruktur, evtl. auch in die Hüllstrukturen benachbarter Subelemente) mit Sn kommt, wodurch der (normalleitende) Widerstand zumindest lokal massiv erhöht wird, und so die Schutzfunktion für den Quenchfall beeinträchtigt wird.

Im Gegensatz dazu sieht die Erfindung vor, das Subelement originär (vor der ersten querschnittsverringernden Umformung) mit einer Hüllstruktur auszustatten, die einen hexagonalen Außenquerschnitt aufweist. In diese Hüllstruktur werden in einen runden Innenquerschnitt die übrigen Teile des Subelements eingesetzt. Wenn dieses zusammengesetzte Subelement einer querschnittsverringernden Umformung unterzogen wird, kann die hexagonale Außenform beibehalten werden. Entsprechend verläuft die querschnittsverringernde Umformung dann sehr gleichmäßig. Alle Wandstärkenverhältnisse können näherungsweiser beibehalten werden, insbesondere über ihren jeweiligen gesamten Umfang. Es gibt keine lokal unterschiedlich stark verformten Teilbereiche eines Subelements, etwa an den Hexagonecken im Verhältnis zu den Hexagonflachseiten (was auch die Anfälligkeit gegenüber Inhomogenitäten reduziert). Entsprechend bleiben die für das Reaktionsglühen vorgesehenen Diffusionslängen überall erhalten, und etwaige eingerichtete Diffusionsbarrieren werden nicht beschädigt. Das Reaktionsglühen nach der querschnittsverringernden Umformung des Fertigleiters, der die Subelemente enthält, kann störungsfrei ablaufen, wobei eine hohe Stromtragfähigkeit erreicht wird und Sn-Kontaminationen in (normalleitend) hoch leitfähige Bereiche werden vermieden.

Die gleichmäßigere Verformung des Subelements im Rahmen einer querschnittsverkleinernden Umformung sorgt zudem dafür, dass die im Rahmen des erfindungsgemäßen RRP-Prozesses im Subelement vorhandenen Nb-haltigen Stabelemente insgesamt radial gleichmäßiger verformt werden, und insbesondere nicht an in Umfangsrichtung unterschiedlichen Stellen unterschiedlich stark gegeneinander verformt werden. Nach dem Reaktionsglühen könnte es im Falle von solchermaßen ungleichmäßig verformten Nb-haltigen Stabelementen vermehrt zu so genanntem "filament bridging" (Brückenschlag/Verbindung zwischen Filamenten) kommen. Solche Verbindungen im Querschnitt des Supraleiters reduzieren die Stromtragfähigkeit, da in den inhomogen verformten Bereichen des Subelements eine homogene und stöchiometrische Bildung von Nb3Sn erschwert wird. Die auf diese Art gebildeten supraleitenden Bereiche haben außerdem lokal größere Querschnitte, was die Induktion von supraleitenden Kreisströmen (z.B. beim Einsatz in einem Magneten) erleichtert. Sowohl die erschwerte Bildung von Nb3Sn als auch die vereinfachte Akkommodation von induzierten Kreisströmen verschlechtern die maximal erzielbare Stromtragfähigkeit nach der Wärmebehandlung drastisch. Im Rahmen der Erfindung kann dieses "filament bridging" erheblich reduziert werden, da die zur Nb3Sn-Bildung vorgesehenen Subelementbestandteile über lange Strecken isoliert bleiben können und dadurch eine Erhöhung der Stromtragfähigkeit erreichbar wird, die erheblich über den Effekt eines größeren nutzbaren Nb3Sn-Flächenanteils in der Fertigleiter-Anordnung hinaus geht. Gleichzeitig können die Umformeigenschaften durch Vermeidung von verbundenen Nb-Stabelementen verbessert werden; die Gefahr von Abrissen ist vermindert.

Man beachte, dass die Nb-haltigen Stabelemente bevorzugt jeweils eine (typischerweise Nb-freie) Filamenthülle aufweisen, deren minimale radiale Wandstärke bevorzugt wenigstens das 0,025-fache, bevorzugt wenigstens das 0,075-fache, des Durchmessers eines Nb-haltigen Kernfilaments beträgt; dann kann das "filament bridging" besonders effizient eingedämmt werden.

Man beachte weiterhin, dass bei "powder in tube"-Prozessen keine vereinzelten Nb3Sn-Zonen in einzelnen PIT-Elementen erzeugt werden, da dort anstelle von ringförmig aneinander anliegenden Nb-haltigen Stabelementen ein Nb-haltiges Rohr eingesetzt wird, das von Hause aus in seiner Homogenität nicht durch ungleichmäßige Umformung verändert werden kann und nach dem Reaktionsglühen immer einen großen zusammenhängenden Flächenbereich von Nb3Sn aufweist.

### Bevorzugte Varianten des Verfahrens zur Herstellung eines Subelements

Bei einer bevorzugten Verfahrensvariante ist vorgesehen, dass zumindest die innere Matrix, der Bereich von aneinander anliegenden Nb-haltigen Stabelementen und die äußere Matrix zunächst zu einem gemeinsamen Einsatzteil zusammengefügt werden und dieses gemeinsame Einsatzteil in den runden Innenquerschnitt der Hüllstruktur eingesetzt wird. Durch die Nutzung eines gemeinsamen Einsatzteils wird das erfindungsgemäße Verfahren vereinfacht und beschleunigt. Alternativ ist es auch möglich, verschiedene Teile einzeln und nacheinander in den runden Innenquerschnitt der Hüllstruktur bzw. zuvor eingesetzte Teile einzusetzen.

Vorteilhaft ist eine Variante, bei der das Subelement mit einer Diffusionsbarriere gefertigt wird, die die äußere Matrix radial umgibt und die direkt oder indirekt radial innen an die Hüllstruktur angelegt wird. Mit der Diffusionsbarriere, die typischerweise rohrförmig ausgebildet ist, kann ein radialer Austritt von Sn aus dem Sn-haltigen Kern in die eigene Hüllstruktur oder gar in die Hüllstrukturen oder äußeren Matrices benachbarter Subelemente verhindert oder minimiert werden. Die Diffusionsbarriere kann beispielsweise aus Nb, Ta oder V gefertigt sein, insbesondere mit wenigstens 50 Gew% Nb, Ta und/oder V.

Bevorzugt ist eine Weiterbildung der obigen beiden Varianten, bei der das gemeinsame Einsatzteil auch die Diffusionsbarriere umfasst. Dies vereinfacht den Verfahrensablauf weiter. Alternativ kann auch die Diffusionsbarriere zunächst allein in den Innenquerschnitt eingesetzt werden, und dann ein Einsatzteil in die im Innenquerschnitt angeordnete Diffusionsbarriere.

Bei einer anderen Weiterbildung umfasst das gemeinsame Einsatzteil auch den Sn-haltigen Kern. Auch dadurch wird der Verfahrensablauf weiter vereinfacht. Alternativ kann auch zunächst das Einsatzteil in den Innenquerschnitt eingesetzt werden, und dann der Sn-haltige Kern in das im Innenquerschnitt angeordnete Einsatzteil.

In den Rahmen der vorliegenden Erfindung fällt zudem auch ein Verfahren zur Herstellung eines Nb3Sn-haltigen Supraleiterdrahts, umfassend folgende Schritte:
- mehrere Subelemente werden erfindungsgemäß wie oben beschrieben gefertigt;
- die gefertigten Subelemente werden einer querschnittsreduzierenden Umformung unterzogen;
- die umgeformten Subelemente werden zu einer Fertigleiter-Anordnung gebündelt, wobei mehrere umgeformte Subelemente aneinander gelegt werden und von einer Cu-haltigen Außenstruktur umschlossen werden;
- die Fertigleiter-Anordnung wird einer querschnittsreduzierenden Umformung unterzogen;
- die umgeformte Fertigleiter-Anordnung wird in eine gewünschte geometrische Form gebracht, insbesondere zu einer Spule gewickelt;
- die in Form gebrachte Fertigleiter-Anordnung wird einer ReaktionsWärmebehandlung unterzogen, bei der das Nb und Sn aus den Subelementen zu Nb3Sn reagiert. Der solchermaßen gefertigte Nb3Sn-Supraleiterdraht erhält beim querschnittsreduzierenden Umformen der Subelemente kaum Verzerrungen in den Subelementen, und kann einen besonders hohen Flächenanteil von Nb3Sn nutzen und eine besonders hohe Stromtragfähigkeit erreichen, wobei auch ein "filament bridging" vermieden oder vermindert werden kann, was die Stromtragfähigkeit weiter erhöht und die Umformeigenschaften verbessert. Zudem ist die Gefahr von Sn-Kontaminationen verringert.

Bevorzugt ist eine Variante dieses Verfahren zur Herstellung eines Nb3Sn-Supraleiterdrahts, die vorsieht,
dass bei der Bündelung zur Fertigleiter-Anordnung zwischen der Außenstruktur, die ein Außenrohr mit einem runden Innenquerschnitt und einem runden Außenquerschnitt aufweist, und den aneinander anliegenden Subelementen ein oder mehrere Füllelemente angeordnet werden,
wobei die Füllelemente nach radial außen ein rundes Profil zur direkten oder indirekten Anlage an eine Innenseite des Außenrohrs aufweisen, und nach radial innen ein gezacktes Profil zur Anlage an die aneinander anliegenden Subelemente aufweisen,
und wobei die Gesamtheit der Füllelemente nach radial innen hin ein näherungsweise kreisförmiges Gesamtprofil ausbildet. Dadurch kann eine ungleichmäßige Verformung von Subelementen bei der querschnittsreduzierenden Umformung der Fertigleiter-Anordnung vermieden oder zumindest reduziert werden, so dass in allen Subelementen die Reaktionswärmebehandlung (Reaktionsglühen) korrekt ablaufen kann. Insbesondere können Deformationen von in der Fertigleiter-Anordnung außen liegenden Subelementen vermieden oder reduziert werden; die Ausbildung von ausgeprägten Ecken in der Gesamtheit der Subelemente, die besonders anfällig für ungleichmäßige Eindellungen sind, wird vermieden. Dadurch wird im fertigen Nb3Sn-Supraleiterdraht die supraleitende Stromtragfähigkeit erhöht und die Gefahr von Sn-Kontaminationen verringert.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

- Fig. 1: zeigt schematisch die Herstellung eines Subelementes für einen Nb3Sn-Supraleiterdraht aus einer Hüllstruktur und übrigen Teilen des Subelements gemäß der Erfindung, in Querschnittsansichten;
- Fig. 2: zeigt in einem schematischen Querschnitt beispielhaft ein Nb-haltiges Stabelement für die Erfindung;
- Fig. 3: zeigt schematisch eine querschnittsreduzierende Umformung des Subelements von Fig. 1 gemäß der Erfindung;
- Fig. 4: zeigt schematisch die Herstellung einer Fertigleiter-Anordnung gemäß der Erfindung, in Querschnittsansichten;
- Fig. 5: zeigt schematisch die querschnittsreduzierende Umformung der Fertigleiter-Anordnung von Fig. 4 gemäß der Erfindung;
- Fig. 6: zeigt schematisch das Wickeln einer Spule mit der umgeformten Fertigleiter-Anordnung gemäß der Erfindung;
- Fig. 7: zeigt schematisch das Reaktionsglühen der Spule von Fig. 6, wodurch eine supraleitende Spule aus Nb3Sn-Supraleiterdraht erhalten wird, gemäß der Erfindung;
- Fig. 8: zeigt schematisch im Querschnitt einen Ausschnitt aus einer FertigleiterAnordnung gemäß der Erfindung, mit an einer Zwischenstruktur anliegenden Subelementen;
- Fig. 9: zeigt schematisch im Querschnitt einen Ausschnitt aus einer FertigleiterAnordnung gemäß der Erfindung, mit Füllelementen, die einen geschlossenen Füllelemente-Ring bilden, mit radial verlaufenden Stößen;
- Fig. 10: zeigt schematisch im Querschnitt einen Ausschnitt aus einer FertigleiterAnordnung gemäß der Erfindung, mit Füllelementen, die einen geschlossenen Füllelemente-Ring bilden, mit schräg verlaufenden Stößen;
- Fig. 11: zeigt schematisch die Herstellung einer Fertigleiter-Anordnung gemäß der Erfindung, in Querschnittsansichten, wobei die Subelemente in ein einzelnen Füllelement eingesetzt werden;
- Fig. 12: zeigt schematisch im Querschnitt ein Subelement für die Erfindung, wobei in eine Hüllstruktur die übrigen Teile des Subelements eingesetzt sind, wobei das Subelement ohne eine Diffusionsbarriere ausgebildet ist;
- Fig. 13: zeigt in schematischem Querschnitt eine einfache Fertigleiter-Anordnung, in der erfindungsgemäß hergestellte Subelemente verbaut wurden;
- Fig. 14: zeigt in schematischer Querschnitt ein einfaches Subelement, das in einer erfindungsgemäßen Fertigleiter-Anordnung verbaut werden kann, und dessen querschnittsreduzierende Umformung;
- Fig. 15: zeigt eine rasterelektronische Aufnahme eines Querschliffs einer Fertigleiter-Anordnung nach dem Stand der Technik nach einer querschnittsreduzierenden Umformung, mit einer Übersichtsaufnahme (oben) und einem vergrößerten Ausschnitt (unten);
- Fig. 16: zeigt eine rasterelektronische Aufnahme eines Querschliffs einer Fertigleiter-Anordnung gemäß der Erfindung nach einer querschnittsreduzierenden Umformung, wobei RRP-Subelemente in einer Anordnung mit näherungsweise kreisförmigem Gesamtprofil durch Füllelemente ergänzt wurden, mit einer Übersichtsaufnahme (oben) und einem vergrößerten Ausschnitt (unten);
- Fig. 17: zeigt eine rasterelektronische Aufnahme eines Querschliffs einer Fertigleiter-Anordnung gemäß der Erfindung nach einer querschnittsreduzierenden Umformung, wobei RRP-Subelemente in einer Anordnung mit näherungsweise kreisförmigem Gesamtprofil durch Füllelemente ergänzt wurden, und bei der bei den RRP-Subelementen jeweils in eine außen hexagonale und innen runde Hüllstruktur das übrige Subelement eingesetzt wurde, mit einer Übersichtsaufnahme (oben) und einem vergrößerten Ausschnitt (unten).

Die Figuren 1 bis 7 illustrieren schematisch die gesamte Herstellung eines Nb3Sn-Supraleiterdrahts im Rahmen der Erfindung, wobei sowohl a) das Subelement erfindungsgemäß aus einer außen hexagonalen und innen runden Hüllstruktur und den übrigen Teilen des Subelements zusammengesetzt wird, als auch b) in der Fertigleiter-Anordnung ein oder (bevorzugt) mehrere Füllelemente zwischen der Gesamtheit der aneinander liegenden Subelemente und der Innenseite eines Außenrohr angeordnet werden. Man beachte jedoch, dass die Erfindung bereits durch die Nutzung nur eines der Aspekte a) oder b) realisiert werden kann.

Die **Fig. 1** zeigt in einer schematischen Querschnittsdarstellung die erfindungsgemäße Herstellung eines Subelements 1 für einen erfindungsgemäßen Nb3Sn-Supraleiterdraht.

Das Subelement 1, siehe der untere Teil der Fig. 1, umfasst einen Sn-haltigen Kern 2, der beispielsweise ein Pulver aus elementarem Sn enthält, und typischerweise kreisrund ausgebildet ist. Der Sn-haltige Kern 2 ist umschlossen von einer inneren Matrix 3, die Cu enthält. Um die innere Matrix 3 herum sind eine Vielzahl von Nb-haltigen Stabelementen 4 angeordnet. Die Nb-haltigen Stabelemente 4 weisen jeweils einen hexagonalen Außenquerschnitt auf und sind aneinander anliegend und die innere Matrix 3 ringförmig umschließend angeordnet.

In der gezeigten Ausführungsform weisen die Nb-haltigen Stabelemente 4 jeweils ein Nb-haltiges Kernfilament 5 (meist einen runden Stab aus elementarem Nb oder einer Legierung mit 50 Gew% oder mehr Nb) und eine Cu-haltige Filamenthülle 6 (meist aus elementarem Cu oder einer Legierung enthaltend 50 Gew% oder mehr Cu) auf, vgl. dazu **Fig. 2****.** Die Filamenthülle 6 ist bevorzugt frei von Nb, kann aber beispielsweise etwas Sn oder andere Zusätze enthalten, um das Diffusionsverhalten während des Reaktionsglühens zu verbessern bzw. einzustellen. Vorliegend gilt für die kleinste radiale Wandstärke WF der Filamenthülle 6 und den größten Durchmesser DM des Kernfilaments 5 ca. WF=0,36^{∗}DM; allgemein bevorzugt ist WF≥0,15^{∗}DM oder sogar WF≥0,25^{∗}DM.

Wieder Bezug nehmend auf Fig. 1, sind die Nb-haltigen Stabelemente 4 wiederum umgeben von einer äußeren Matrix 7, die Cu enthält. Die äußere Matrix 7 besitzt ein rundes Außenprofil. In der gezeigten Ausführungsform wird die äußere Matrix 7 von einer Diffusionsbarriere 8 umgeben, die beispielsweise aus Nb gefertigt ist. Diese blockiert etwaiges Sn aus dem Kern 2, das während des Reaktionsglühens in die äußere Matrix 7 durchdringen könnte, in radialer Richtung. Die Diffusionsbarriere 8 weist eine einheitliche Wandstärke auf und ist außen rund ausgebildet.

Die Diffusionsbarriere 8 ist wiederum umschlossen von einer Hüllstruktur 9, die Cu enthält und typischerweise aus elementarem Kupfer oder einer Legierung mit wenigstens 50 Gew% Cu gefertigt ist. Die Hüllstruktur 9 besitzt einen runden Innenquerschnitt und einen hexagonalen Außenquerschnitt.

Zur Fertigung des Subelements 1 wird die Hüllstruktur 9 separat gefertigt, und bereits dabei mit einem hexagonalen Außenquerschnitt und einem runden Innenquerschnitt ausgebildet. In den runden Innenquerschnitt bzw. das Innere der Hüllstruktur 9 werden die übrigen Teile des Subelements 1 eingesetzt. Bevorzugt werden dabei, wie in Fig. 1 dargestellt, zumindest die innere Matrix 3, die Nb-haltigen Stabelemente 4 und die äußere Matrix 7 zunächst zu einem gemeinsamen Eisatzteil 10 zusammengefügt und dann wird das gemeinsame Einsatzteil 10 in die Hüllstruktur 9 eingesetzt.

In der gezeigten Ausführungsform umfasst das gemeinsame Einsatzteil 10 auch den Sn-haltigen Kern 2 und die Diffusionsbarriere 8, so dass alle übrigen Teile des Subelements 1 zusammen in die Hüllstruktur 9 eingesetzt werden. Alternativ könnte aber auch beispielsweise die Diffusionsbarriere 8 zunächst allein in die Hüllstruktur 9 eingesetzt werden, und dann in die Diffusionsbarriere 8 das Einsatzteil 10; ebenso könnte der Sn-haltige Pulverkern 2 erst nach dem Einsetzen des Einsatzteils 10 in die Hüllstruktur 9 in das Einsatzteil 10 eingefügt werden (jeweils nicht näher dargestellt).

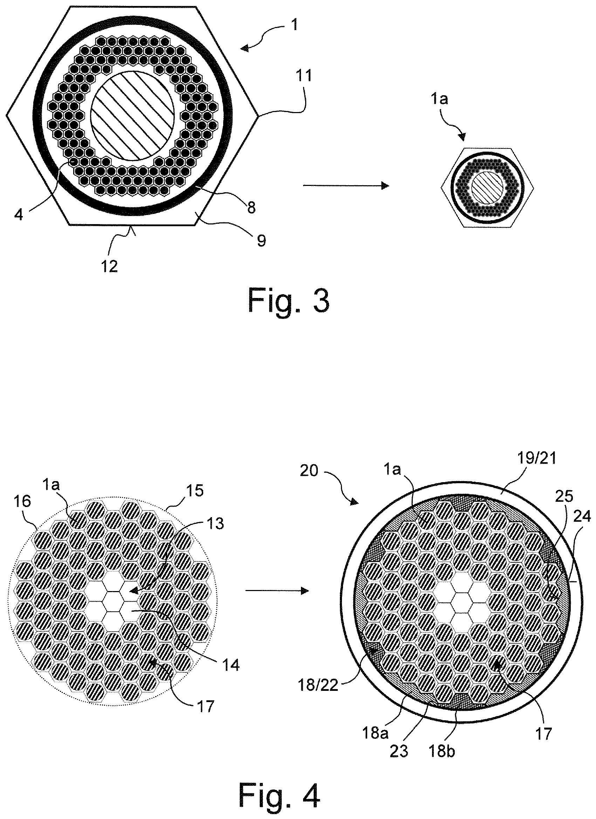

Das solchermaßen gefertigte Subelement 1 wird nun einer querschnittsreduzierenden Umformung unterzogen, wie in **Fig. 3** dargestellt. Dabei kann die äußere Gestalt beibehalten werden; es kommt nur zu einer proportionalen Verkleinerung des Querschnitts beim umgeformten (etwa gezogenen) Subelement 1a, das also auch einen hexagonalen Außenquerschnitt aufweist. Soweit Material innerhalb der Querschnittsebene umverteilt wird, erfolgt diese Umverteilung nur radial, und insbesondere nicht azimuthal; die Hauptumverteilung von Material findet dabei in axialer Richtung (in "Zugrichtung", senkrecht zur Ebene der gezeigten Querschnitte) statt. Insbesondere wird die Anordnung der Nb-haltigen Stabelementen 4 nicht in eine hexagonale Form gezwungen, und es erfolgt keine Ausdünnung etwa der Diffusionsbarriere 8 nahe den Hexagonlängsseiten 12. Die Wandstärkenverhältnisse bleiben über den gesamten Umfang gleich. Weiterhin behalten die Nb-haltigen Stabelemente 4 ihre relative Position im Subelement 1/1a, und werden insbesondere nicht lokal flachgedrückt oder auf andere Nb-haltigen Stabelemente 4 zu gedrückt.

Sodann werden mehrere gezogene Subelemente 1a gebündelt, wie in **Fig. 4** links dargestellt. Dabei sind die gezogenen Subelemente 1a vereinfachend als Hexagone mit einem schraffierten Kreis dargestellt.

In der gezeigten Variante werden hier 78 Subelemente 1a aneinander anliegend angeordnet, wobei eine Zentralstruktur 13 nicht mit Subelementen 1a, sondern mit hier sieben hexagonalen Zentralelementen 14 eingerichtet wird. Die Zentralelemente 14 enthalten Cu (und sind beispielsweise aus elementarem Cu oder einer Cu-Legierung mit wenigstens 50 Gew% Cu gefertigt).

Die Gesamtheit 17 der Subelemente 1a bildet radial außenseitig einen näherungsweise kreisförmiges Gesamtprofil aus; insbesondere kann innerhalb eines (gepunktet dargestellten, gedachten) Umkreises 15, der durch die Spitzen 16 der am weitesten radial hervorstehenden Subelemente 1a verläuft, nirgends ein weiteres Subelement radial außen an die Gesamtheit 17 der Subelemente 1a angefügt werden, ohne dass dieses weitere, angefügte Subelement zumindest teilweise außerhalb des Umkreises 15 liegen würde.

Sodann werden zur Fertigung einer Fertigleiter-Anordnung 20, vgl. Fig. 4 rechts, außenseitig an die Subelemente 1a mehrere Füllelemente 18a, 18b angelegt; in der gezeigten Variante gibt es zwei Geometrien (Typen) von Füllelementen 18a, 18b, wobei sich die beiden Geometrien 18a, 18b in Umfangsrichtung abwechseln. Insgesamt werden hier zwölf Füllelemente 18a, 18b eingesetzt.

Die Füllelemente 18a, 18b weisen nach radial außen hin ein rundes Profil 24 auf, und nach radial innen hin ein gezacktes Profil 25. Das gezackte Profil 25 entspricht der lokal angrenzenden Außenkontur der Gesamtheit 17 der Subelemente 1a.

Die Gesamtheit 18 der Füllelemente 18a, 18b bildet nach radial außen hin ein umlaufendes kreisrundes Profil aus. Nach radial innen hin bildet die Gesamtheit 18 der Füllelemente 18a-18b näherungsweise ein kreisförmiges Gesamtprofil aus, entsprechend dem äußeren Gesamtprofil der Gesamtheit 17 der Subelemente 1a.

Um die Füllelemente 18a, 18b herum wird ein Außenrohr 19 angeordnet. In der gezeigten Variante liegen die Füllelemente 18a, 18b mit ihren runden Profilen 24 direkt an einer runden Innenseite des Außenrohrs 19 an. Das Außenrohr 19 bildet hier die Außenstruktur 21 der Fertigleiter-Anordnung 20 aus. Die Außenstruktur 21 enthält Cu, bevorzugt wenigstens 50 Gew% Cu; in der gezeigten Ausführungsform ist das Außenrohr 19 zu diesem Zweck aus elementarem Cu gefertigt. Das Außenrohr 19 ist zu seiner Außenseite hin ebenfalls rund ausgebildet.

In der gezeigten Variante bildet die Gesamtheit 18 der Füllelemente 18a, 18b einen geschlossenen, umlaufenden Füllelemente-Ring 22 aus, wobei die Füllelemente 18a, 18b aneinandergrenzen und dort jeweils kurze, radial verlaufende Stöße 23 ausbilden. Die Füllelemente 18a, 18b sind hier aus Cu oder einer Cu-haltigen Legierung mit wenigstens 50 Gew% Cu gefertigt, so dass die Füllelemente 18a, 18b als auch das Außenrohr 19 als ohmsche Umgehungsstrompfade im Falle eines Quenchs (plötzlicher Verlust der Supraleitung) zum Schutz des später entstehenden Nb3Sn-Supraleiterdrahts dienen können. Eine Zwischenstruktur aus die Diffusion von Sn blockierendem Material ist hier nicht nötig, da die einzelnen Subelemente 1a bereits mit Diffusionsbarrieren ausgestattet sind (vgl. Fig. 1, Bzz. 8).

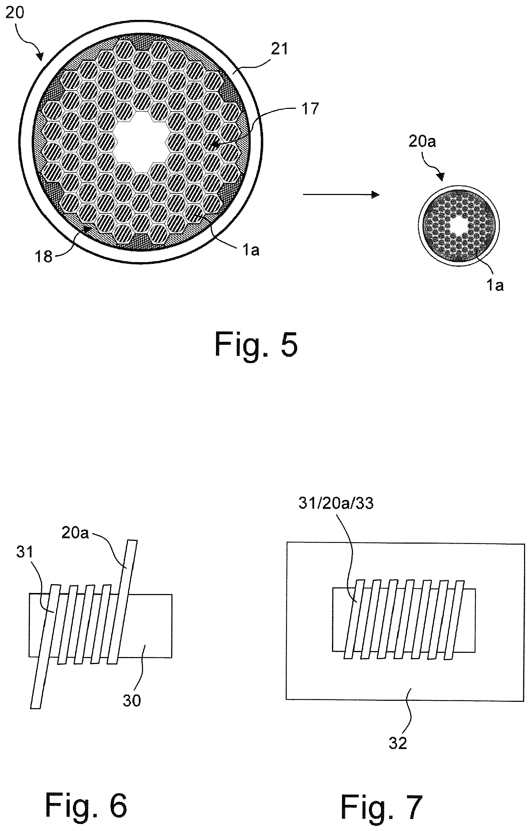

Nachdem die Gesamtheit 17 der Subelemente 1a und die Gesamtheit 18 der Füllelemente 18a, 18b in der Außenstruktur 21 angeordnet wurden, erfolgt eine querschnittsverringernde Umformung der Fertigleiter-Anordnung 20, vgl. **Fig. 5****.** Dabei kommt es wiederum nur zu einer proportionalen Verkleinerung des Querschnitts bei der umgeformten (etwa gezogenen) Fertigleiter-Anordnung 20a. Da die Füllelemente 18a, 18b keine merklichen Freiräume lassen, und die Gesamtheit 18 der Füllelemente 18a, 18b und die Gesamtheit 17 der Subelemente 1a im Wesentlichen rotationssymmetrisch aufgebaut sind, erfolgen Materialumverteilungen in der Querschnittsebene im Wesentlichen gleichmäßig radial, und insbesondere nicht azimuthal; die Hauptumverteilung von Material findet dabei in axialer Richtung (in "Zugrichtung", senkrecht zur Ebene der gezeigten Querschnitte) statt. Insbesondere werden keine einzelnen Subelemente 1a besonders eingedellt, sondern alle Subelemente erfahren im Wesentlichen die gleiche, proportionale Verkleinerung ihrer Querschnittsfläche. In den Subelementen 1a erfolgt keine lokale Ausdünnung etwa der Diffusionsbarriere, und auch kein lokales Zusammendrücken von Nb-haltigen Stabelementen 4 in den Subelementen 1a. Die Wandstärkenverhältnisse bleiben über den gesamten Umfang eines jeweiligen Subelements bei allen Subelementen 1a näherungsweise gleich.

Die solchermaßen erhaltene, umgeformte (etwa gezogene) Fertigleiter-Anordnung 20a kann nun in eine für die Anwendung gewünschte Form gebracht werden, etwa auf einem Wickelkörper 30 zu einer Spule 31 gewickelt werden, wie in **Fig. 6** dargestellt. Falls gewünscht, kann zuvor noch beispielsweise eine Vertwistung und/oder eine Verseilung von umgeformten Fertigleiter-Anordnungen 20a erfolgen (nicht näher dargestellt).

Sodann wird die in die gewünschte Form gebrachte Fertigleiter-Anordnung 20a, hier die Spule 31, einer Reaktionswärmebehandlung (auch genannt Reaktionsglühen) unterzogen, wofür sie typischerweise in einem Ofen 32 angeordnet wird, vgl. **Fig. 7**. Die Reaktionswärmebehandlung sieht typischerweise mehrere Wärmebehandlungsstufen (Temperaturplateaus, an denen eine konstante Temperatur für einige Zeit, meist einige Stunden, gehalten wird) vor, etwa ein Temperaturplateau um 210°, ein weiteres Temperaturplateau um 350°C-400°C und ein Temperaturplateau um 650-750°C. Während der Wärmebehandlung diffundiert Sn aus den Sn-haltigen Kernen der Subelemente zu den Nb-haltigen Stabelementen der Subelemente, und es entsteht Nb3Sn; mit anderen Worten, aus der umgeformten und in die gewünschte Form gebrachten Fertigeiter-Anordnung 20a entsteht ein Nb3Sn-Supraleiterdraht 33. Dabei bilden sich durch die Subelemente und die Nb-haltigen Stabelemente vorgegebene, im Querschnitt gänzlich oder teilweise voneinander getrennte Nb3Sn-Zonen, die jeweils entlang ihrer Längsachse (Erstreckungsrichtung des Drahtes) supraleitend Strom tragen können, und insgesamt einen Strom besonders großer Stromstärke supraleitend tragen können.

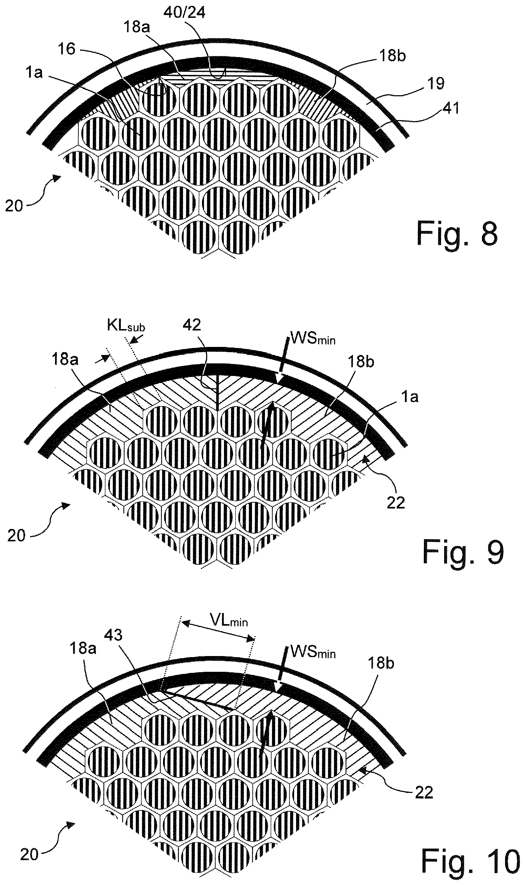

Die **Fig. 8** zeigt eine Variante einer Fertigleiter-Anordnung 20 für die Erfindung in einem schematischen Querschnitt, wobei nur ein sektorförmiger Teil der Fertigleiter-Anordnung 20 dargestellt ist (letzteres gilt auch für Fig. 9 und Fig. 10).

Bei der in Fig. 8 gezeigten Variante ergänzen sich die radial am weitesten vorstehenden Spitzen 16 der Subelemente 1a und die äußeren, runden Profile 24 der Füllelemente 18a, 18b zu einer kreisbogenförmigen Kontur 40; diese ist die kreisbogenförmige Kontur 40 mit dem kleinstmöglichen Radius, die durch eine maximale Zahl von Spitzen 16 verläuft und gleichzeitig alle Subelemente 1a einschließt. Die in Umfangsrichtung aufeinander folgenden Füllelemente 18a, 18b, die hier eine alternierende Geometrie aufweisen, werden jeweils durch Spitzen 16 voneinander getrennt. Diese Bauform ist besonders kompakt, und erreicht im finalen Nb3Sn-Supraleiterdraht einen besonders hohen Flächenanteil von Nb3Sn.

In der gezeigten Bauform ist zwischen dem Außenrohr 19 und den Füllelementen 18a, 18b eine rohrförmige Zwischenstruktur 41 angeordnet. Diese rohrförmige Zwischenstruktur 41 ist hier aus einem Material gefertigt, das die Diffusion von Sn von innen nach außen zum Außenrohr 19 hin blockiert oder zumindest behindert; bevorzugt ist die Zwischenstruktur dafür aus Nb, Ta oder V oder einer Legierung auf Basis dieser Elemente ausgebildet.

Die in **Fig. 9** gezeigte Variante einer Fertigleiter-Anordnung 20 für die Erfindung weist Füllelemente 18a, 18b auf, die einen umlaufenden Füllelemente-Ring 22 ausbilden. Die minimale Wandstärke WSₘᵢₙ des Füllelemente-Rings 22 in radialer Richtung ist hier ungefähr genauso groß wie die Kantenlänge KL_{sub} eines Subelements 1a, also WSₘᵢₙ=KL_{sub}. Durch ausreichend große, minimale Wandstärken des Füllelemente-Rings 22 kann sichergestellt werden, dass dieser eine Funktion in der Fertigleiter-Anordnung übernehmen kann, etwa eine zusätzliche Behinderung der Diffusion von Sn nach radial außen (wofür das Füllelemente-Material entsprechend gewählt werden muss), oder auch für ein günstiges, beispielsweise vermittelndes Verformungsverhalten.

In der in Fig. 9 gezeigten Ausführungsform ist der Stoß 42 zwischen den Füllelementen 18a, 18b radial ausgerichtet, wodurch der Füllelemente-Ring 22 besonders einfach zu fertigen ist.

Es ist aber auch möglich, bei einer Fertigleiter-Anordnung 20 gemäß der Erfindung einen schräg zur radialen Richtung RR verlaufenden Stoß 43 an zwischen in Umfangsrichtung benachbarten Füllelementen 18a, 18b eines Füllelemente-Rings 22 einzurichten, wie in **Fig. 10** dargestellt. Die Diffusion von Sn kann an Stößen in der Regel schneller ablaufen als durch Vollmaterial. Durch Einrichtung eines schrägen Stoßes 43 kann die Länge des Stoßes 43 vergrößert werden, und damit die Diffusion entlang des Stoßes 43 verzögert werden. In der gezeigten Variante ist die kleinste Verlaufslänge VLₘᵢₙ aller Stöße 43 in der Fertigleiter-Anordnung 20 ca. 5 mal so lang wie die kleinste radiale Wandstärke WSₘᵢₙ im Füllelemente-Ring 22, also VLₘᵢₙ=5^{∗}WSₘᵢₙ.

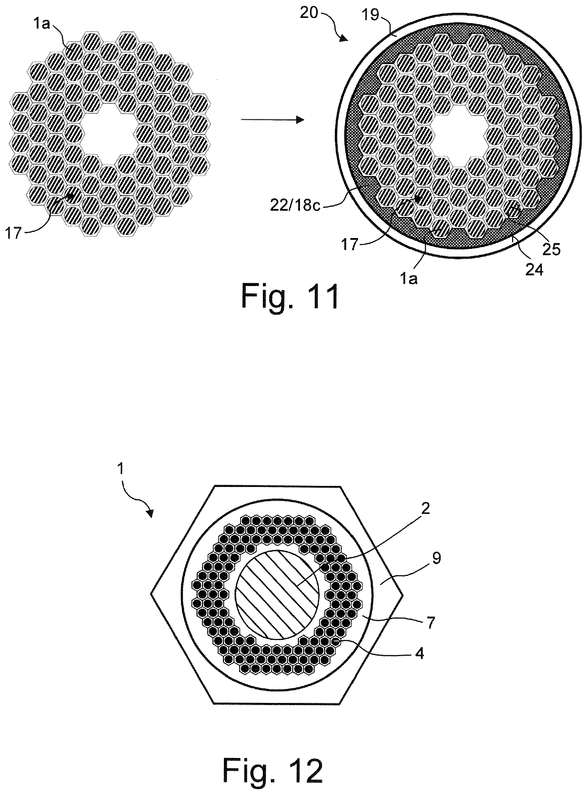

In der **Fig. 11** ist das Zusammenfügen einer Fertigleiter-Anordnung 20 gemäß der Erfindung illustriert, wobei die gebündelten, aneinander anliegenden Subelemente 1a in ein einziges, umlaufendes Füllelement 18c eingefügt werden, welches außen ein umlaufendes, rundes Profil 24 und innen ein gezacktes Profil 25 entsprechend der Außenkontur der Gesamtheit 17 der Subelemente 1a aufweist.

Das Füllelement 18c bildet damit auch einen geschlossenen Füllelemente-Ring 22 aus. Das Füllelement 18c wird hier direkt an der Innenseite eines Außenrohrs 19 angeordnet, um die Fertigleiter-Anordnung 20 zu erhalten.

Die Fertigung des einzigen Füllelements 18c ist zwar schwieriger als die Fertigung eines Satzes von Füllelementen, die gemeinsam die Gesamtheit 17 der Füllelemente 1a umschließen; jedoch ist das Zusammenführen der Subelemente 1a und des Füllelements 18c vereinfacht, da nicht mehrere Füllelemente gleichzeitig gehandhabt werden müssen. Zudem werden Stöße zwischen Füllelementen, die einen schnellen Diffusionspfad für Sn bilden können, vermieden.

Die **Fig. 12** zeigt ein Subelement 1 für die Erfindung, bei dem die Hüllstruktur 9 innenseitig direkt an der äußeren Matrix 7 anliegt, welche die Nb-haltigen Stabelemente 4 umgibt. Hier wurde ein gemeinsames Einsatzteil aus Sn-haltigem Kern 2, innerer Matrix 3, Nb-haltigen Stabelementen 4 und äußerer Matrix 7 in die Hüllstruktur 9, die außen hexagonal und innen rund ausgebildet ist, eingesetzt.

Diese Bauform weist keine Diffusionsbarriere auf. Dadurch kann ein höherer Flächenanteil an Nb3Sn im fertigen Nb3Sn-Supraleiterdraht erhalten werden; gleichzeitig sollte aber das Reaktionsglühen so geführt werden, dass die Diffusion von Sn aus dem Sn-haltigen Kern 2 dann möglichst wenig über den Bereich der Nb-haltigen Stabelemente 4 hinaus fortschreitet. Im Rahmen der Erfindung ist eine gute Kontrolle über die Form der Subelemente 1 erreichbar, sowohl bei einer querschnittsreduzierenden Umformung der Subelemente 1, als auch bei einer querschnittsreduzierenden Umformung der Fertigleiter-Anordnung, so dass eine Kontrolle der Diffusion von Sn über die Prozessführung des Reaktionsglühens ohne Diffusionsbarrieren grundsätzlich möglich ist.

Für eine größere Sicherheit können jedoch Diffusionsbarrieren im Bereich der Außenstruktur der Fertigleiter-Anordnung (etwa eine die Sn-Diffusion behindernde Zusatzstruktur, oder auch ein die Sn-Diffusion behindernder Füllelemente-Ring, vgl. Fig. 4 und Fig. 8 und Fig. 9) vorgesehen werden, insbesondere wenn die Anwendung des Nb3Sn-Supraleiterdrahts eine starke Biegung der Fertigleiter-Anordnung (und damit ungleichmäßige Verzerrungen des Drahtquerschnitts) erfordert, etwa beim Verkabeln oder beim Spulenwickeln.

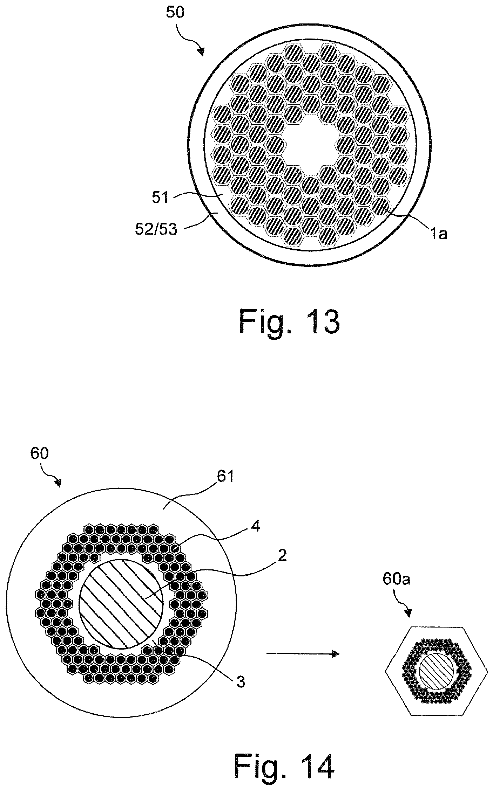

Wenn bereits durch die außen hexagonale und innen runde Hüllstruktur, in die die übrigen Teile des Subelements eingesetzt werden, eine ausreichende Steigerung von Stromtragfähigkeit und Sicherheit bezüglich einer etwaigen Sn-Kontamination von (normalleitend) hoch leitfähigen Bereichen erreicht wird, kann auch ein einfacherer Aufbau einer Fertigleiter-Anordnung 50 gewählt werden, bei der keine Füllemente eingesetzt werden, vgl. **Fig. 13****.** Die gebündelten Subelemente 1a werden hier direkt in Außenrohr 52 mit einem runden Innenquerschnitt eingesetzt, und um die Subelemente 1a verbleiben Freiräume (Leerräume) 51. Das Außenrohr 52 bildet hier die Außenstruktur 53 der Fertigleiter-Anordnung 50.

Falls bereits durch die Verwendung von Füllelementen um die Subelemente herum bei der Fertigleiter-Anordnung eine ausreichende Steigerung von Stromtragfähigkeit und Sicherheit bezüglich einer etwaigen Sn-Kontamination von (normalleitend) hoch leitfähigen Bereichen erreicht wird, kann auch ein einfacherer Aufbau eines Subelements 60 gewählt werden, vgl. **Fig. 14****.** Die Nb-haltigen Stabelemente 4 sind hier lediglich von einer außen runden, äußeren Matrix 61 umgeben. Bei der querschnittsreduzierenden Umformung wird dann der äußeren Matrix 61 eine hexagonale Außenform aufgeprägt, vgl. das umgeformte (gezogene) Subelement 60a.

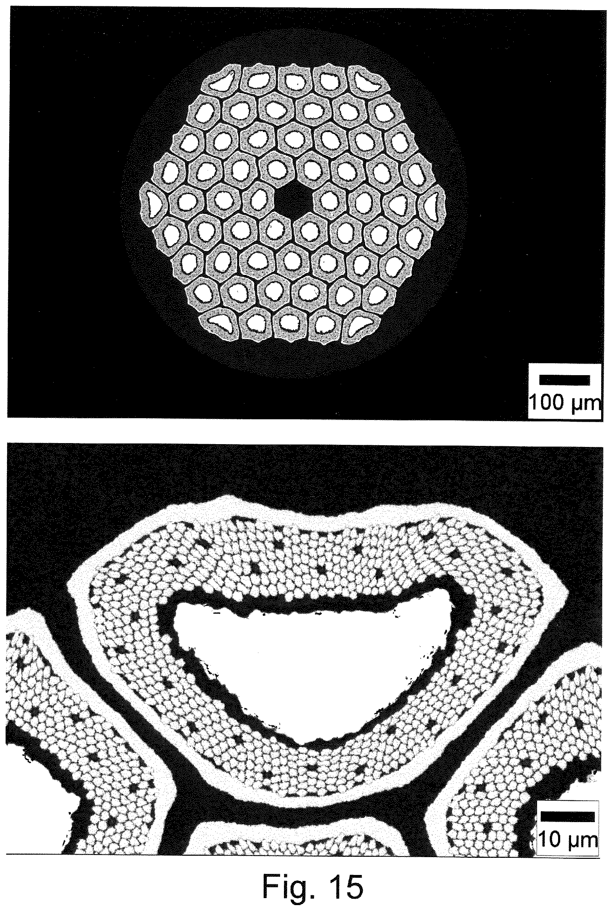

Die **Fig. 15** zeigt beispielhaft eine Fertigleiter-Anordnung nach einer querschnittsreduzierenden Umformung nach dem Stand der Technik. Bei der Fertigung wurden RRP-Subelemente in einer hexagonalen Anordnung in eine im Innenquerschnitt hexagonale Außenstruktur eingesetzt. Die RRP-Elemente wurden zuvor bei einer querschnittsreduzierenden Umformung von einem runden Querschnitt auf einen hexagonalen Querschnitt umgeformt.

In der Übersichtsaufnahme (oben) ist gut zu erkennen, dass die randständigen und vor allem die eckständigen RRP-Subelemente stark verformt werden. Die eckständigen Subelemente werden so stark deformiert, dass sich eine näherungsweise dreieckförmige Gestalt für den Sn-haltigen Kern (heller Bereich in der Mitte eines jeweiligen Subelements) ergibt. In der Vergrößerung (unten) eines typischen eckständigen Subelements kann auch erkannt werden, dass ein Großteil der Nb-haltigen Stabelemente eine Deformation erfährt, durch die der jeweilige Querschnitt näherungsweise oval wird, wobei ein durchschnittliches Aspektverhältnis von schätzungsweise ca. 1,5 bis 2 erhalten wird, und bei einem nicht unerheblichen Teil der Nb-haltigen Stabelemente (vor allem über den oberen Ecken des dreieckförmigen Sn-haltigen Kerns) auch ein deutlich größeres Aspektverhältnis von bis zu ca. 3 erhalten wird. Die "radiale" Dicke des Bereichs von aneinander liegenden Nb-haltigen Stabelementen sowie die Dicke der Diffusionsbarriere (in der Figur hell, um den Bereich der Nb-haltigen Stabelemente herum angeordnet) variieren stark.

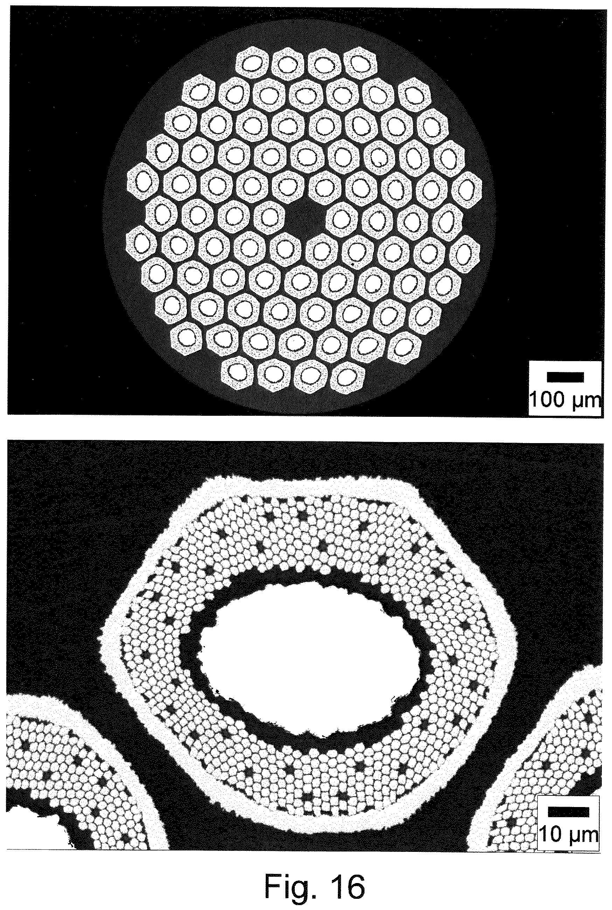

Die **Fig. 16** zeigt eine Fertigleiter-Anordnung gemäß der Erfindung nach einer querschnittsreduzierenden Umformung, wobei RRP-Subelemente in einer Anordnung mit näherungsweise kreisförmigem Gesamtprofil durch Füllelemente ergänzt wurden und in ein Außenrohr mit rundem Innenquerschnitt eingesetzt wurden. Die RRP-Elemente wurden zuvor bei einer querschnittsreduzierenden Umformung von einem runden Querschnitt auf einen hexagonalen Querschnitt umgeformt.

Durch den Einsatz der Füllelemente wird gegenüber dem Stand der Technik eine deutlich geringere Deformation der randständigen und vor allem der eckständigen RRP-Subelemente erreicht, was sowohl in der Übersichtsaufnahme (oben) als auch in der Vergrößerung (unten) eines typischen eckständigen Subelements gut zu erkennen ist. Der Sn-haltige Kern wird, wie in der Vergrößerung (unten) zu erkennen ist, nur geringfügig oval verzerrt. Die einzelnen Nb-haltigen Stabelemente sind zu einem großen Teil nicht merklich deformiert; die Nb-haltigen Stabelemente weisen ein durchschnittliches Aspektverhältnis von schätzungsweise ca. 1,1 bis 1,2 auf, und bei einzelnen Nb-haltigen Stabelementen tritt auch ein Aspektverhältnis von bis zu ca. 1,5 auf. Die "radiale" Dicke des Bereichs von Nb-haltigen Stabelementen und die Dicke der Diffusionsbarriere (in der Figur hell) variieren im Wesentlichen entsprechend der aufgeprägten hexagonalen Form.

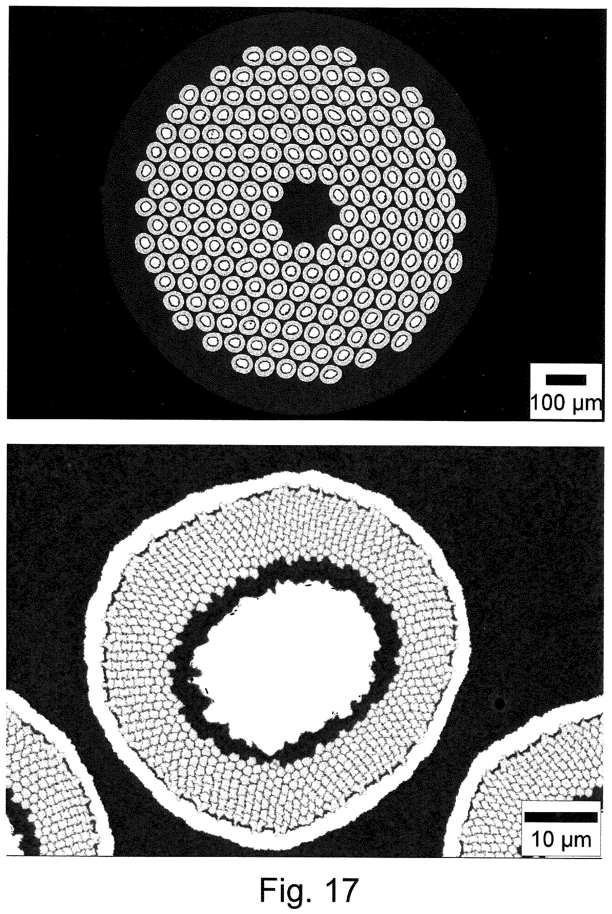

**Fig. 17** zeigt schließlich eine Fertigleiter-Anordnung gemäß der Erfindung nach einer querschnittsreduzierenden Umformung, wobei RRP-Subelemente in einer Anordnung mit näherungsweise kreisförmigem Gesamtprofil durch Füllelemente ergänzt wurden und in ein Außenrohr mit rundem Innenquerschnitt eingesetzt wurden, und wobei bei den RRP-Subelementen in eine außen hexagonale und innen runde Hüllstruktur zuvor das übrige Subelement eingesetzt wurde.

Durch den Einsatz der Füllelemente wird auch hier gegenüber dem Stand der Technik eine deutlich geringere Deformation der randständigen und vor allem der eckständigen RRP-Subelemente erreicht, was sowohl in der Übersichtsaufnahme (oben) als auch in der Vergrößerung (unten) eines typischen eckständigen Subelements gut zu erkennen ist. Der Sn-haltige Kern bleibt näherungsweise kreisrund. Durch die Verwendung einer außen hexagonalen und innen runden, zu befüllenden Hüllstruktur für ein jeweiliges RRP-Subelement kann die Deformation der Nb-haltigen Stabelemente bei der anschließenden querschnittsreduzierenden Umformung der jeweiligen RRP-Subelemente minimiert werden. Entsprechend sind auch im Fertigleiter die einzelnen Nb-haltigen Stabelemente im Querschnitt kaum deformiert. Die "radiale" Dicke des Bereichs von Nb-haltigen Stabelementen sowie die Dicke der Diffusionsbarriere variieren nur geringfügig, entsprechend der geringen ungleichmäßigen Deformation des RRP-Subelements.

Zusammenfassend schlägt die Erfindung vor, bei der Herstellung eines Nb3Sn-Supraleiterdrahts (33) nach dem RRP-Prinzip eine Fertigleiter-Anordnung (20; 50) einzusetzen, bei der hexagonale RRP-Subelemente (1a; 60a) zu einem näherungsweise im Querschnitt kreisförmigen Bündel zusammengefasst werden und zusammen mit Füllelementen (18a-18c) in einem innen und außen runden Außenrohr (19; 52) angeordnet werden. Die Füllelemente (18a-18c) bilden nach innen ein gezacktes Profil (25) zur Anlage an die hexagonalen Subelemente (1a; 60a) und nach außen ein rundes Profil (24) zur direkten oder indirekten Anlage im Außenrohr aus. Dadurch werden bei einer querschnittsreduzierenden Umformung der Fertigleiter-Anordnung (20, 50) ungleichmäßige Verformungen, insbesondere Eindellungen, an den Subelementen (1a, 60a) minimiert. Bei der Fertigung der RRP-Subelemente (1; 60) schlägt die Erfindung vor, diese vor einer querschnittsreduzierenden Umformung mit einer außen hexagonalen und innen runden Hüllstruktur (9) zu fertigen, in welche die übrigen Teile des Subelements (1; 60) eingesetzt werden, insbesondere eine ringförmige Anordnung von hexagonalen Nb-haltigen Stabelementen (4), die außen von einer äußeren Matrix (7, 61) und innen von einer inneren Matrix (3) umschlossen sind. Bei einer anschließenden querschnittsreduzierenden Umformung der Subelemente (1; 60) sind wiederum ungleichmäßige Verformungen, insbesondere azimutale Materialumverteilungen, minimiert. Insgesamt kann ein Nb3Sn-Supraleiterdraht (33) mit hoher supraleitender Stromtragfähigkeit und minimierter Gefahr von Sn-Verunreinigungen in normalleitenden Bereichen, und damit guter Schutzfunktion im Quenchfall, erreicht werden.

### Bezugszeichenliste

- 1: (nicht umgeformtes) Subelement
- 1b: (umgeformtes) Subelement
- 2: Sn-haltiger Kern
- 3: innere Matrix
- 4: Nb-haltiges Stabelement
- 5: Nb-haltiges Kernfilament
- 6: Cu-haltige Filamenthülle
- 7: äußere Matrix
- 8: Diffusionsbarriere
- 9: Hüllstruktur
- 10: gemeinsames Einsatzteil
- 11: Hexagoneck
- 12: Hexagonlängsseite
- 13: Zentralstruktur
- 14: Zentralelement
- 15: Umkreis
- 16: Spitze
- 17: Gesamtheit der Subelemente
- 18: Gesamtheit der Füllelemente
- 18a-b: Füllelemente
- 18c: (einziges) Füllelement
- 19: Außenrohr
- 20: (nicht umgeformte) Fertigleiter-Anordnung
- 20a: (umgeformte) Fertigleiter-Anordnung
- 21: Außenstruktur
- 22: Füllelemente-Ring
- 23: Stoß
- 24: rundes Profil
- 25: gezacktes Profil
- 30: Wickelkörper
- 31: Spule
- 32: Ofen
- 33: Nb3Sn-Supraleiterdraht
- 40: kreisbogenförmige Kontur
- 41: Zwischenstruktur
- 42: Stoß
- 43: schräger Stoß
- 50: Fertigleiter-Anordnung (ohne Füllelemente)
- 51: Freiraum
- 52: Außenrohr
- 53: Außenstruktur
- 60: (nicht umgeformtes) Subelement (ohne außen hexagonale und innen runde Hüllstruktur)
- 60a: (umgeformtes) Subelement (ohne außen hexagonale und innen runde Hüllstruktur)
- 61: äußere Matrix
- DM: Durchmesser Kernfilament
- KL_{sub}: Kantenlänge eines hexagonalen Subelements
- VLₘᵢₙ: kleinste Verlaufslänge schräger Stoß
- WF: (kleinste) Wandstärke Filamenthülle
- WSₘᵢₙ: minimale Wandstärke Füllelemente-Ring

## Patentansprüche

1. Fertigleiter-Anordnung (20) für einen Nb3Sn-Supraleiterdraht (33), umfassend
- mehrere aneinander anliegende Subelemente (1a; 60a), die jeweils Nb und Sn enthalten und die jeweils im Außenquerschnitt hexagonal ausgebildet sind, und
- eine Außenstruktur (21), die Cu enthält und die die aneinander anliegenden Subelemente (1a; 60a) umgibt, wobei die Außenstruktur (21) im Außenquerschnitt rund ausgebildet ist,
wobei die Subelemente (1a, 60a) jeweils ausgebildet sind mit
- einem Sn-haltigen Kern (2),
- einer inneren Matrix (3), die Cu enthält und die den Sn-haltigen Kern (2) umgibt,
- einen Bereich von aneinander anliegenden Nb-haltigen Stabelementen (4), die jeweils im Außenquerschnitt hexagonal ausgebildet sind, insbesondere wobei die Nb-haltigen Stabelemente (4) jeweils mit einem Nb-haltigen Kernfilament (5) und einer Cu-haltigen Filamenthülle (6) ausgebildet sind,
- einer äußeren Matrix (7; 61), die Cu enthält und den Bereich von Nb-haltigen Stabelementen (4) umgibt;
**dadurch gekennzeichnet,**
**dass** die Außenstruktur (21) mit einem Außenrohr (19) ausgebildet ist, das im Außenquerschnitt und im Innenquerschnitt rund ausgebildet ist,
**dass** zwischen dem Außenrohr (19) und den aneinander anliegenden Subelementen (1a, 60a) ein oder mehrere Füllelemente (18a-18c) angeordnet sind, die nach radial außen ein rundes Profil (24) zur direkten oder indirekten Anlage an eine Innenseite des Außenrohrs (19) aufweisen, und die nach radial innen ein gezacktes Profil (25) zur Anlage an die aneinander anliegenden Subelemente (1a; 60a) aufweisen,
wobei an die aneinander anliegenden Subelemente (1a, 60a) außenseitig das eine oder die mehreren Füllelemente (18a-18c) angelegt sind, und an das radial äußere, runde Profil (24) des einen oder der mehreren Füllelemente (18a-18c) direkt oder indirekt das Außenrohr (19) angelegt ist, und dass die Gesamtheit (18) der Füllelemente (18a-18c) nach radial innen hin ein näherungsweise kreisförmiges Gesamtprofil ausbildet.

2. Fertigleiter-Anordnung (20) nach Anspruch 1, **dadurch gekennzeichnet, dass** die Fertigleiter-Anordnung (20) mehrere Füllelemente (18a-18b) umfasst, und dass radial am weitesten vorstehende Spitzen (16) der Gesamtheit (17) der aneinander anliegenden Subelemente (1a; 60a) und die runden Profile (24) der Füllelemente (18a-18b) sich zu einer kreisförmigen Kontur (40) ergänzen, wobei die Füllelemente (18a-18b) so ausgebildet sind, dass die kreisförmige Kontur (40) einen minimalen Radius aufweist.

3. Fertigleiter-Anordnung (20) nach Anspruch 1, **dadurch gekennzeichnet, dass** das oder die Füllelemente (18a-18c) einen umlaufenden Füllelemente-Ring (22) ausbilden, innerhalb dessen die Gesamtheit (17) der aneinander anliegenden Subelemente (1a; 60a) angeordnet ist,
insbesondere wobei für eine minimale radiale Wandstärke WSₘᵢₙ des Füllelemente-Rings (22) gilt: WSₘᵢₙ≥0,3^{∗}KL_{sub}, mit KL_{sub}: Kantenlänge eines hexagonalen Subelements (1a; 60a).

4. Fertigleiter-Anordnung (20) nach Anspruch 3, **dadurch gekennzeichnet, dass** der Füllelemente-Ring (22) mehrere Füllelemente (18a-18b) umfasst, und dass Stöße (43) zwischen in Umfangsrichtung benachbarten Füllelementen (18a-18b) im Füllelemente-Ring (22) zumindest teilweise, bevorzugt vollständig, schräg zur radialen Richtung verlaufen,
insbesondere wobei für eine kleinste Verlaufslänge VLₘᵢₙ aller Verlaufslängen der jeweiligen Stöße (43) gilt: VLₘᵢₙ≥2^{∗}WSₘᵢₙ, mit WSₘᵢₙ: minimale radiale Wandstärke des Füllelemente-Rings (22).

5. Fertigleiter-Anordnung (20) nach einem der Ansprüche 1 bis 4, **dadurch gekennzeichnet, dass** das eine oder die mehreren Füllelemente (18a-18c) Cu enthalten.

6. Fertigleiter-Anordnung (20) nach einem der Ansprüche 3 oder 4, **dadurch gekennzeichnet, dass** die Füllelemente (18a-18c) des Füllelemente-Rings (22) aus einem Material gefertigt sind, das dazu geeignet ist, die Diffusion von Sn aus den Subelementen (1a; 60a) in das Außenrohr (19) während einer Reaktionswärmebehandlung, bei der das Nb und Sn aus den Subelementen (1a; 60a) zu Nb3Sn reagieren, zu blockieren oder zu behindern, insbesondere wobei die Füllelemente (18a-18c) Nb, Ta und/oder V enthalten.

7. Fertigleiter-Anordnung (20) nach einem der vorhergehenden Ansprüche, **dadurch gekennzeichnet, dass** die Fertigleiter-Anordnung (20) mehrere Füllelemente (18a-18b) mit unterschiedlicher Geometrie umfasst, insbesondere wobei insgesamt zwölf Füllelemente (18a-18b) mit zwei verschiedenen Geometrien vorhanden sind.

8. Fertigleiter-Anordnung (20) nach einem der vorhergehenden Ansprüche, **dadurch gekennzeichnet, dass** eine Zwischenstruktur (41), insbesondere ein Zwischenrohr, radial zwischen der Innenseite des Außenrohrs (19) und den runden Profilen (24) des oder der Füllelemente (18a-18c) vorhanden ist.

9. Fertigleiter-Anordnung (20) nach Anspruch 8, **dadurch gekennzeichnet, dass** die Zwischenstruktur (41) aus einem Material gefertigt ist, das dazu geeignet ist, die Diffusion von Sn aus den Subelementen (1a; 60a) in das Außenrohr (19) während einer Reaktionswärmebehandlung, bei der das Nb und Sn aus den Subelementen (1a; 60a) zu Nb3Sn reagieren, zu blockieren oder zu behindern,
insbesondere wobei die Zwischenstruktur (41) Nb, Ta und/oder V enthält.

10. Fertigleiter-Anordnung (20) nach einem der vorhergehenden Ansprüche, **dadurch gekennzeichnet, dass** die Subelemente (1a; 60a) weiterhin ausgebildet sind mit
- einer Diffusionsbarriere (8), die die äußere Matrix (7; 61) radial umgibt, und
- einer Hüllstruktur (9), die Cu enthält und die die Diffusionsbarriere (8) radial umgibt.

11. Fertigleiter-Anordnung (20) nach einem der vorhergehenden Ansprüche, **dadurch gekennzeichnet, dass** in der Fertigleiter-Anordnung (20) eine Zentralstruktur (13) vorhanden ist, die von den aneinander anliegenden Subelementen (1a; 60a) umgeben ist, wobei die Zentralstruktur (13) Cu-haltig ist,
insbesondere wobei die Zentralstruktur (13) ein oder mehrere Zentralelemente (14) enthält, die im Außenquerschnitt hexagonal ausgebildet sind.

12. Verfahren zur Fertigung eines Nb₃Sn-haltigen Supraleiterdrahts (33), umfassend die folgenden Schritte:
- eine Fertigleiter-Anordnung (20) nach einem der Ansprüche 1 bis 11 wird einer querschnittsreduzierenden Umformung unterzogen;
- die umgeformte Fertigleiter-Anordnung (20a) wird in eine gewünschte geometrische Form gebracht, insbesondere zu einer Spule (31) gewickelt;
- die in Form gebrachte Fertigleiter-Anordnung (20a) wird einer ReaktionsWärmebehandlung unterzogen, bei der das Nb und Sn aus den Subelementen (1a; 60a) zu Nb3Sn reagieren.

13. Verfahren nach Anspruch 12, **dadurch gekennzeichnet,**
**dass** die Subelemente (1) ausgebildet werden mit einer Hüllstruktur (9), die Cu enthält und an die die äußere Matrix (7) radial innen direkt oder indirekt angelegt wird,
**dass** zur Fertigung eines jeweiligen Subelements (1) für die Fertigleiter-Anordnung (20) die Hüllstruktur (9) separat mit einem runden Innenquerschnitt und einem hexagonalen Außenquerschnitt gefertigt wird, und die übrigen Teile des Subelements (1) anschließend in den runden Innenquerschnitt der Hüllstruktur (9) eingesetzt werden,
und **dass** die jeweiligen Subelemente (1) einer querschnittsreduzierenden Umformung unterzogen werden und zu einer Fertigleiter-Anordnung (20) nach einem der Ansprüche 1 bis 11 gebündelt werden.

14. Verfahren zur Herstellung eines Subelements (1) für einen Nb3Sn-Supraleiterdraht (33),
wobei das Subelement (1) Nb und Sn enthält und im Außenquerschnitt hexagonal ausgebildet ist,
und wobei das Subelement (1) ausgebildet ist mit
- einem Sn-haltigen Kern (2),
- einer inneren Matrix (3), die Cu enthält und die den Sn-haltigen Kern (2) umgibt,
- einen Bereich von aneinander anliegenden Nb-haltigen Stabelementen (4), die jeweils im Außenquerschnitt hexagonal ausgebildet sind, insbesondere wobei die Nb-haltigen Stabelemente (4) jeweils mit einem Nb-haltigen Kernfilament (5) und einer Cu-haltigen Filamenthülle (6) ausgebildet sind,
- einer äußeren Matrix (7), die Cu enthält und den Bereich von Nb-haltigen Stabelementen (4) umgibt,
- einer Hüllstruktur (9), die Cu enthält und an der die äußere Matrix (7) radial innen direkt oder indirekt anliegt;
**dadurch gekennzeichnet,**
**dass** die Hüllstruktur (9) separat mit einem runden Innenquerschnitt und einem hexagonalen Außenquerschnitt gefertigt wird,
und **dass** die übrigen Teile des Subelements (1) anschließend in den runden Innenquerschnitt der Hüllstruktur (9) eingesetzt werden.

15. Verfahren nach Anspruch 14, **dadurch gekennzeichnet, dass** zumindest die innere Matrix (3), der Bereich von aneinander anliegenden Nb-haltigen Stabelementen (4) und die äußere Matrix (7) zunächst zu einem gemeinsamen Einsatzteil (10) zusammengefügt werden und dieses gemeinsame Einsatzteil (10) in den runden Innenquerschnitt der Hüllstruktur (9) eingesetzt wird.

16. Verfahren nach einem der Ansprüche 14 oder 15, **dadurch gekennzeichnet, dass** das Subelement (1) mit einer Diffusionsbarriere (8) gefertigt wird, die die äußere Matrix (7) radial umgibt und die direkt oder indirekt radial innen an die Hüllstruktur (9) angelegt wird.

17. Verfahren nach den Ansprüchen 15 und 16, **dadurch gekennzeichnet, dass** das gemeinsame Einsatzteil (10) auch die Diffusionsbarriere (8) umfasst.

18. Verfahren nach einem der Ansprüche 15 bis 17, **dadurch gekennzeichnet, dass** das gemeinsame Einsatzteil (10) auch den Sn-haltigen Kern (2) umfasst.

19. Verfahren zur Herstellung eines Nb3Sn-haltigen Supraleiterdrahts (33), umfassend folgende Schritte:
- mehrere Subelemente (1) werden nach einem der Ansprüche 14 bis 18 gefertigt;
- die gefertigten Subelemente (1) werden einer querschnittsreduzierenden Umformung unterzogen;
- die umgeformten Subelemente (1a) werden zu einer Fertigleiter-Anordnung (20; 50) gebündelt, wobei mehrere umgeformte Subelemente (1a) aneinander gelegt werden und von einer Cu-haltigen Außenstruktur (21; 53) umschlossen werden;
- die Fertigleiter-Anordnung (20, 50) wird einer querschnittsreduzierenden Umformung unterzogen;
- die umgeformte Fertigleiter-Anordnung (20a) wird in eine gewünschte geometrische Form gebracht, insbesondere zu einer Spule (31) gewickelt;
- die in Form gebrachte Fertigleiter-Anordnung (20a) wird einer ReaktionsWärmebehandlung unterzogen, bei der das Nb und Sn aus den Subelementen (1a) zu Nb3Sn reagiert.

20. Verfahren nach Anspruch 19, **dadurch gekennzeichnet,**
**dass** bei der Bündelung zur Fertigleiter-Anordnung (20) zwischen der Au-ßenstruktur (21), die ein Außenrohr (19) mit einem runden Innenquerschnitt und einem runden Außenquerschnitt aufweist, und den aneinander anliegenden Subelementen (1a) ein oder mehrere Füllelemente (18a-18c) angeordnet werden,
wobei die Füllelemente (18a-18c) nach radial außen ein rundes Profil (24) zur direkten oder indirekten Anlage an eine Innenseite des Außenrohrs (19) aufweisen, und nach radial innen ein gezacktes Profil (25) zur Anlage an die aneinander anliegenden Subelemente (1a) aufweisen,
und wobei die Gesamtheit (18) der Füllelemente (18a-18c) nach radial innen hin ein näherungsweise kreisförmiges Gesamtprofil ausbildet.

## Claims

1. A final conductor arrangement (20) for an Nb3Sn superconductor wire (33), comprising
- a plurality of mutually abutting subelements (1a; 60a) each comprising Nb and Sn and each being configured hexagonally in external cross section, and
- an outer structure (21) which comprises Cu and which surrounds the mutually abutting subelements (1a; 60a), the outer structure (21) being configured to be round in external cross section,
where the subelements (1a, 60a) are each configured with
- an Sn-containing core (2),
- an inner matrix (3) which comprises Cu and which surrounds the Sn-containing core (2),
- a region of mutually abutting Nb-containing rod elements (4), which are each configured hexagonally in external cross section, more particularly where the Nb-containing rod elements (4) are each configured with an Nb-containing core filament (5) and a Cu-containing filament casing (6),
- an outer matrix (7; 61) which comprises Cu and surrounds the region of Nb-containing rod elements (4);
**characterized**
**in that** the outer structure (21) is configured with an outer tube (19) which is configured to be round in external cross section and internal cross section,
**in that** between the outer tube (19) and the mutually abutting subelements (1a, 60a), one or more filling elements (18a-18c) are arranged which radially to the outside have a round profile (24) for direct or indirect abutment against an inside of the outer tube (19), and which radially to the inside have a serrated profile (25) for abutment against the mutually abutting subelements (1a; 60a),
wherein the one or more filling element(s) (18a-18c) is/are applied to the outer side of the mutually abutting subelements (1a, 60a), and the outer tube (19) is applied directly or indirectly to the radially outer round profile (24) of the one or more filling element(s) (18a-18c),
and **in that** the entirety (18) of the filling elements (18a-18c), radially toward the inside, form an approximately circular overall profile.

2. The final conductor arrangement (20) as claimed in claim 1, **characterized in that** the final conductor arrangement (20) comprises a plurality of filling elements (18a-18b), and **in that** tips (16) projecting radially furthest of the entirety (17) of the mutually abutting subelements (1a; 60a) combine with the round profiles (24) of the filling elements (18a-18b) to form a circular contour (40), with the filling elements (18a-18b) being configured such that the circular contour (40) has a minimal radius.

3. The final conductor arrangement (20) as claimed in claim 1, **characterized in that** the one or more filling elements (18a-18c) form a surrounding filling element ring (22) within which the entirety (17) of the mutually abutting subelements (1a; 60a) are arranged,
more particularly where the condition for a minimal radial wall thickness WSₘᵢₙ of the filling element ring (22) is as follows: WSₘᵢₙ≥0.3^{∗}KL_{sub}, where KL_{sub} is the edge length of a hexagonal subelement (1a; 60a).

4. The final conductor arrangement (20) as claimed in claim 3, **characterized in that** the filling element ring (22) comprises a plurality of filling elements (18a-18b), and **in that** joints (43) between filling elements (18a-18b) adjacent in the peripheral direction in the filling element ring (22) extend at least partially, preferably completely, diagonally with respect to the radial direction,
more particularly where the condition for a smallest length of extent VLₘᵢₙ of all the lengths of extent of the respective joints (43) is as follows: VLₘᵢₙ≥2^{∗}WSₘᵢₙ, where WSₘᵢₙ is the minimal radial wall thickness of the filling element ring (22).

5. The final conductor arrangement (20) as claimed in any of claims 1 to 4, **characterized in that** the one or more filling elements (18a-18c) comprise Cu.

6. The final conductor arrangement (20) as claimed in either of claims 3 and 4, **characterized in that** the filling elements (18a-18c) of the filling element ring (22) are fabricated from a material which is suitable for blocking or hindering the diffusion of Sn from the subelements (1a; 60a) into the outer tube (19) during a reactive heat treatment wherein the Nb and Sn from the subelements (1a; 60a) react to form Nb3Sn,
in particular where the filling elements (18a-18c) comprise Nb, Ta and/or V.

7. The final conductor arrangement (20) as claimed in any of the preceding claims, **characterized in that** the final conductor arrangement (20) comprises a plurality of filling elements (18a-18b) having different geometries,
in particular where there are a total of twelve filling elements (18a-18b) having two different geometries.

8. The final conductor arrangement (20) as claimed in any of the preceding claims, **characterized in that** an intermediate structure (41), more particularly an intermediate tube, is present radially between the inside of the outer tube (19) and the round profiles (24) of the one or more filling elements (18a-18c).

9. The final conductor arrangement (20) as claimed in claim 8, **characterized in that** the intermediate structure (41) is fabricated from a material which is suitable for blocking or hindering the diffusion of Sn from the subelements (1a; 60a) into the outer tube (19) during a reactive heat treatment wherein the Nb and Sn from the subelements (1a; 60a) react to form Nb3Sn,
more particularly where the intermediate structure (41) comprises Nb, Ta and/or V.

10. The final conductor arrangement (20) as claimed in any of the preceding claims, **characterized in that** the subelements (1a; 60a) are additionally configured with
- a diffusion barrier (8), which radially surrounds the outer matrix (7; 61), and
- a casing structure (9) which comprises Cu and which radially surrounds the diffusion barrier (8).

11. The final conductor arrangement (20) as claimed in any of the preceding claims, **characterized in that** in the final conductor arrangement (20) there is a central structure (13) which is surrounded by the mutually abutting subelements (1a; 60a), where the central structure (13) is Cu-containing,
more particularly where the central structure (13) comprises one or more central elements (14) which are configured hexagonally in external cross section.

12. A method for fabricating an Nb₃Sn-containing superconductor wire (33), comprising the following steps:
- subjecting a final conductor arrangement (20) as claimed in any of claims 1 to 11 to a reshaping with a reduction in cross section;
- bringing the reshaped final conductor arrangement (20a) into a desired geometric form, more particularly by winding to form a coil (31);
- subjecting the final conductor arrangement (20a), brought into form, to a reactive heat treatment wherein the Nb and Sn from the subelements (1a; 60a) react to form Nb3Sn.

13. The method as claimed in claim 12, **characterized**
**in that** the subelements (1) are configured with a casing structure (9) which comprises Cu and against which the outer matrix (7) is abutted directly or indirectly radially on the inside,
**in that**, for fabricating a respective subelement (1) for the final conductor arrangement (20), the casing structure (9) is fabricated separately with a round internal cross section and a hexagonal external cross section, and the remaining parts of the subelement (1) are subsequently inserted into the round internal cross section of the casing structure (9),
and **in that** the respective subelements (1) are subjected to a reshaping with a reduction in cross section and are bundled to form a final conductor arrangement (20) as claimed in any of claims 1 to 11.

14. A method for producing a subelement (1) for an Nb3Sn superconductor wire (33),
where the subelement (1) comprises Nb and Sn and is configured hexagonally in external cross section,
and where the subelement (1) is configured with
- an Sn-containing core (2),
- an inner matrix (3) which comprises Cu and which surrounds the Sn-containing core (2),
- a region of mutually abutting Nb-containing rod elements (4), which are each configured hexagonally in external cross section, more particularly where the Nb-containing rod elements (4) are each configured with an Nb-containing core filament (5) and a Cu-containing filament casing (6),
- an outer matrix (7) which comprises Cu and surrounds the region of Nb-containing rod elements (4),
- a casing structure (9) which comprises Cu and against which the outer matrix (7) abuts directly or indirectly radially on the inside;
**characterized**
**in that** the casing structure (9) is fabricated separately with a round internal cross section and a hexagonal external cross section,
and **in that** the remaining parts of the subelement (1) are subsequently inserted into the round internal cross section of the casing structure (9).

15. The method as claimed in claim 14, **characterized in that** at least the inner matrix (3), the region of mutually abutting Nb-containing rod elements (4) and the outer matrix (7) are first assembled into a unified insert part (10), and this unified insert part (10) is inserted into the round internal cross section of the casing structure (9).

16. The method as claimed in either of claims 14 and 15, **characterized in that** the subelement (1) is fabricated with a diffusion barrier (8) which radially surrounds the outer matrix (7) and which is abutted directly or indirectly against the casing structure (9) radially on the inside.

17. The method as claimed in claims 15 and 16, **characterized in that** the unified insert part (10) also comprises the diffusion barrier (8).

18. The method as claimed in any of claims 15 to 17, **characterized in that** the unified insert part (10) also comprises the Sn-containing core (2).

19. A method for producing an Nb3Sn-containing superconductor wire (33), comprising the following steps:
- fabricating a plurality of subelements (1) as claimed in any of claims 14 to 18;
- subjecting the fabricated subelements (1) to a reshaping with reduction in cross section;
- bundling the reshaped subelements (1a) to form a final conductor arrangement (20; 50), where a plurality of reshaped subelements (1a) are placed against one another and are surrounded by a Cu-containing outer structure (21; 53);
- subjecting the final conductor arrangement (20, 50) to a reshaping with reduction in cross section;
- bringing the reshaped final conductor arrangement (20a) into a desired geometric form, more particularly by winding to form a coil (31);
- subjecting the final conductor arrangement (20a), brought into form, to a reactive heat treatment wherein the Nb and Sn from the subelements (1a) react to form Nb3Sn.

20. The method as claimed in claim 19, **characterized**
**in that** during the bundling to form the final conductor arrangement (20), one or more filling elements (18a-18c) are arranged between the outer structure (21), which comprises an outer tube (19) having a round internal cross section and a round external cross section, and the mutually abutting subelements (1a),
where the filling elements (18a-18c) radially outward have a round profile (24) for direct or indirect abutment against an inside of the outer tube (19), and radially inward have a serrated profile (25) for abutment against the mutually abutting subelements (1a),
and where the entirety (18) of the filling elements (18a-18c) radially toward the inside form an approximately circular overall profile.

## Revendications

1. Ensemble (20) de conducteurs finis, dévolu à un fil supraconducteur Nb₃Sn (33) et comprenant
- plusieurs sous-éléments (1a ; 60a) mutuellement en applique qui renferment, à chaque fois, du Nb et du Sn et présentent, respectivement, une réalisation à section transversale extérieure hexagonale, et
- une structure externe (21) renfermant du Cu et entourant lesdits sous-éléments (1a ; 60a) mutuellement en applique, laquelle structure externe (21) présente une réalisation à section transversale extérieure ronde,
lesdits sous-éléments (1a, 60a) comportant, à chaque fois,
- un noyau (2) renfermant du Sn,
- une matrice interne (3) qui renferme du Cu et entoure ledit noyau (2) renfermant du Sn,
- une région constituée d'éléments longilignes (4) mutuellement en applique, renfermant du Nb et présentant, respectivement, une réalisation à section transversale extérieure hexagonale, sachant notamment que lesdits éléments longilignes (4), renfermant du Nb, sont respectivement munis d'un filament d'âme (5) renfermant du Nb et d'une gaine filamentaire (6) renfermant du Cu,
- une matrice externe (7 ; 61) qui renferme du Cu et entoure ladite région constituée d'éléments longilignes (4) renfermant du Nb ;
**caractérisé par le fait**
**que** la structure externe (21) est pourvue d'un tube externe (19) présentant une réalisation à sections transversales extérieure et intérieure rondes ;
**qu'**un ou plusieurs élément(s) de remplissage (18a-18c) interposé(s) entre le tube externe (19) et les sous-éléments (1a, 60a) mutuellement en applique est (sont) doté(s) d'un profil rond (24), vers l'extérieur dans le sens radial, en vue de la venue en contact directe ou indirecte avec une face intérieure dudit tube externe (19), et d'un profil dentelé (25), vers l'intérieur dans le sens radial, en vue de la venue en contact avec lesdits sous-éléments (1a ; 60a) mutuellement en applique,
sachant que l'élément, ou la multiplicité d'éléments de remplissage (18a-18c) est mis(e) en place extérieurement contre les sous-éléments (1a, 60a) mutuellement en applique, et le tube externe (19) est directement ou indirectement mis en place contre le profil rond (24), radialement extérieur, dudit élément ou de ladite multiplicité d'éléments de remplissage (18a-18c) ;
et **que** l'intégralité (18) desdits éléments de remplissage (18a-18c) donne naissance, vers l'intérieur dans le sens radial, à un profil global approximativement circulaire.

2. Ensemble (20) de conducteurs finis, selon la revendication 1, **caractérisé par le fait que** ledit ensemble (20) de conducteurs finis inclut plusieurs éléments de remplissage (18a-18b) ; et **par le fait que** des pointes (16) faisant saillie au maximum, dans le sens radial, au-delà de l'intégralité (17) des sous-éléments (1a ; 60a) mutuellement en applique, et les profils ronds (24) desdits éléments de remplissage (18a-18b), se complètent pour former une configuration circulaire (40), lesdits éléments de remplissage (18a-18b) étant conçus de façon telle que ladite configuration circulaire (40) présente un rayon minimal.

3. Ensemble (20) de conducteurs finis, selon la revendication 1, **caractérisé par le fait que** l'élément, ou les éléments de remplissage (18a-18c) donne(nt) naissance à un anneau périphérique (22) d'éléments de remplissage à l'intérieur duquel est disposée l'intégralité (17) des sous-éléments (1a ; 60a) mutuellement en applique,
sachant notamment qu'une épaisseur de paroi radiale minimale WSₘᵢₙ dudit anneau (22) d'éléments de remplissage obéit à l'expression : WSₘᵢₙ ≥ 0,3^{∗}KL_{sub}, KL_{sub} étant la longueur d'arête d'un sous-élément (1a ; 60a) hexagonal.

4. Ensemble (20) de conducteurs finis, selon la revendication 3, **caractérisé par le fait que** l'anneau (22) d'éléments de remplissage inclut plusieurs éléments de remplissage (18a-18b) ;
et **par le fait que** des zones de rencontre (43) entre des éléments de remplissage (18a-18b) circonférentiellement voisins dans ledit anneau (22) d'éléments de remplissage s'étendent au moins en partie, de préférence en totalité, à l'oblique par rapport à la direction radiale,
sachant notamment qu'une longueur de tracé VLₘᵢₙ la plus petite, parmi toutes les longueurs de tracés des zones de rencontre (43) considérées, obéit à l'expression : VLₘᵢₙ ≥ 2^{∗} WSₘᵢₙ, WSₘᵢₙ étant l'épaisseur de paroi radiale minimale dudit anneau (22) d'éléments de remplissage.

5. Ensemble (20) de conducteurs finis, selon l'une des revendications 1 à 4, **caractérisé par le fait que** l'élément, ou la multiplicité d'éléments de remplissage (18a-18c) renferme du Cu.

6. Ensemble (20) de conducteurs finis, selon l'une des revendications 3 ou 4, **caractérisé par le fait que** les éléments de remplissage (18a-18c) de l'anneau (22) d'éléments de remplissage sont produits en un matériau propre à bloquer ou à gêner la diffusion de Sn dans le tube externe (19), à partir des sous-éléments (1a ; 60a), lors d'un traitement thermique de réaction au cours duquel le Nb et le Sn provenant desdits sous-éléments (1a ; 60a) entrent en réaction pour produire du Nb₃Sn,
sachant notamment que lesdits éléments de remplissage (18a-18c) renferment du Nb, du Ta et/ou du V.

7. Ensemble (20) de conducteurs finis, selon l'une des revendications précédentes, **caractérisé par le fait que** ledit ensemble (20) de conducteurs finis inclut plusieurs éléments de remplissage (18a-18b) à géométries différentes,
sachant notamment que douze éléments de remplissage (18a-18b), offrant deux géométries différentes, sont présents au total.

8. Ensemble (20) de conducteurs finis, selon l'une des revendications précédentes, **caractérisé par le fait qu'**une structure intercalaire (41), un tube intercalaire en particulier, est présent(e) radialement entre la face intérieure du tube externe (19) et les profils ronds (24) de l'élément, ou des éléments de remplissage (18a-18c).

9. Ensemble (20) de conducteurs finis, selon la revendication 8, **caractérisé par le fait que** la structure intercalaire (41) est produite en un matériau propre à bloquer ou à gêner la diffusion de Sn dans le tube externe (19), à partir des sous-éléments (1a ; 60a), lors d'un traitement thermique de réaction au cours duquel le Nb et le Sn provenant desdits sous-éléments (1a ; 60a) entrent en réaction pour produire du Nb₃Sn,
sachant notamment que ladite structure intercalaire (41) renferme du Nb, du Ta et/ou du V.

10. Ensemble (20) de conducteurs finis, selon l'une des revendications précédentes, **caractérisé par le fait que** les sous-éléments (1a ; 60a) comportent, par ailleurs,
- une barrière antidiffusion (8), qui entoure radialement la matrice externe (7 ; 61) et
- une structure d'enveloppement (9), qui renferme du Cu et entoure radialement ladite barrière antidiffusion (8).

11. Ensemble (20) de conducteurs finis, selon l'une des revendications précédentes, **caractérisé par** la présence, dans ledit ensemble (20) de conducteurs finis, d'une structure centrale (13) entourée par les sous-éléments (1a ; 60a) mutuellement en applique, laquelle structure centrale (13) renferme du Cu,
sachant notamment que ladite structure centrale (13) contient un ou plusieurs élément(s) central (centraux) (14) présentant une réalisation à section transversale extérieure hexagonale.

12. Procédé de fabrication d'un fil supraconducteur (33) à teneur Nb₃Sn, incluant les étapes suivantes :
- un ensemble (20) de conducteurs finis, conforme à l'une des revendications 1 à 11, est soumis à un remodelage diminuant la section transversale ;
- l'ensemble remodelé (20a) de conducteurs finis est amené à une forme géométrique souhaitée, notamment enroulé en une bobine (31) ;
- ledit ensemble (20a) de conducteurs finis, mis en forme, est soumis à un traitement thermique de réaction au cours duquel le Nb et le Sn, provenant des sous-éléments (1a ; 60a), entrent en réaction pour produire du Nb₃Sn.

13. Procédé selon la revendication 12, **caractérisé par le fait que** les sous-éléments (1) sont pourvus d'une structure d'enveloppement (9) qui renferme du Cu et contre laquelle la matrice externe (7) est directement ou indirectement mise en place, intérieurement dans le sens radial ;
que, pour produire un sous-élément (1) considéré, dédié à l'ensemble (20) de conducteurs finis, ladite structure d'enveloppement (9) est produite séparément avec une section transversale intérieure ronde et une section transversale extérieure hexagonale, et les parties restantes dudit sous-élément (1) sont ensuite insérées dans ladite section transversale intérieure ronde de ladite structure d'enveloppement (9) ;
et que les sous-éléments (1) respectifs sont soumis à un remodelage diminuant la section transversale et sont regroupés en un ensemble (20) de conducteurs finis, conforme à l'une des revendications 1 à 11.

14. Procédé de fabrication d'un sous-élément (1) destiné à un fil supraconducteur Nb₃Sn (33),
lequel sous-élément (1) renferme du Nb et du Sn, et présente une réalisation à section transversale extérieure hexagonale,
sachant que ledit sous-élément (1) comporte
- un noyau (2) renfermant du Sn,
- une matrice interne (3) qui renferme du Cu et entoure ledit noyau (2) renfermant du Sn,
- une région constituée d'éléments longilignes (4) mutuellement en applique, renfermant du Nb et présentant, respectivement, une réalisation à section transversale extérieure hexagonale, sachant notamment que lesdits éléments longilignes (4), renfermant du Nb, sont respectivement munis d'un filament d'âme (5) renfermant du Nb et d'une gaine filamentaire (6) renfermant du Cu,
- une matrice externe (7), qui renferme du Cu et entoure ladite région constituée d'éléments longilignes (4) renfermant du Nb,
- une structure d'enveloppement (9), qui renferme du Cu et contre laquelle ladite matrice externe (7) est directement ou indirectement mise en place, intérieurement dans le sens radial ;
**caractérisé par le fait**
**que** la structure d'enveloppement (9) est produite séparément avec une section transversale intérieure ronde et une section transversale extérieure hexagonale ;
et **que** les parties restantes du sous-élément (1) sont ensuite insérées dans ladite section transversale intérieure ronde de ladite structure d'enveloppement (9).

15. Procédé selon la revendication 14, **caractérisé par le fait qu'**au moins la matrice interne (3), la région constituée d'éléments longilignes (4) mutuellement en applique et renfermant du Nb, et la matrice externe (7), sont tout d'abord assemblées en une pièce intégrée (10) commune, et cette pièce intégrée (10) commune est insérée dans la section transversale intérieure ronde de la structure d'enveloppement (9).

16. Procédé selon l'une des revendications 14 ou 15, **caractérisé par le fait que** le sous-élément (1) est doté d'une barrière antidiffusion (8), qui entoure radialement la matrice externe (7) et est directement ou indirectement mise en place contre la structure d'enveloppement (9), intérieurement dans le sens radial.

17. Procédé selon les revendications 15 et 16, **caractérisé par le fait que** la pièce intégrée (10) commune inclut également la barrière antidiffusion (8).

18. Procédé selon l'une des revendications 15 à 17, **caractérisé par le fait que** la pièce intégrée (10) commune inclut également le noyau (2) renfermant du Sn.

19. Procédé de fabrication d'un fil supraconducteur (33) à teneur Nb₃Sn, incluant les étapes suivantes :
- plusieurs sous-éléments (1) sont produits en conformité avec l'une des revendications 14 à 18 ;
- les sous-éléments (1) produits sont soumis à un remodelage diminuant la section transversale ;
- les sous-éléments (1a) remodelés sont regroupés en un ensemble (20 ; 50) de conducteurs finis, plusieurs sous-éléments (1a) remodelés étant placés mutuellement en applique, et étant ceinturés par une structure externe (21 ; 53) qui renferme du Cu ;
- ledit ensemble (20, 50) de conducteurs finis est soumis à un remodelage diminuant la section transversale ;
- l'ensemble remodelé (20a) de conducteurs finis est amené à une forme géométrique souhaitée, notamment enroulé en une bobine (31) ;
- ledit ensemble (20a) de conducteurs finis, mis en forme, est soumis à un traitement thermique de réaction au cours duquel le Nb et le Sn, provenant desdits sous-éléments (1a), entrent en réaction pour produire du Nb₃Sn.

20. Procédé selon la revendication 19, **caractérisé par le fait**
**que**, lors du regroupement visant à obtenir l'ensemble (20) de conducteurs finis, un ou plusieurs élément(s) de remplissage (18a-18c) est (sont) interposé(s) entre les sous-éléments (1a), mutuellement en applique, et la structure externe (21) pourvue d'un tube externe (19) présentant une section transversale intérieure ronde et une section transversale extérieure ronde,
les éléments de remplissage (18a-18c) étant dotés d'un profil rond (24), vers l'extérieur dans le sens radial, en vue de la venue en contact directe ou indirecte avec une face intérieure dudit tube externe (19), et d'un profil dentelé (25), vers l'intérieur dans le sens radial, en vue de la venue en contact avec lesdits sous-éléments (1a) mutuellement en applique,
sachant que l'intégralité (18) desdits éléments de remplissage (18a-18c) donne naissance, vers l'intérieur dans le sens radial, à un profil global approximativement circulaire.
